# EUROPEAN PATENT APPLICATION

(11) **EP 2 221 898 A1**
(43) Date of publication of application: **25.08.2010**
(21) Application number: 08854836.7
(22) Date of filing: 27.11.2008
(51) Int. Cl.: H01L 51/50, C09K 11/06, H05B 33/10

(54) **ORGANIC ELECTROLUMINESCENT DEVICE AND METHOD FOR MANUFACTURING THE SAME**

(30) Priority: 29.11.2007 JP 2007308492
(71) Applicant: Sumitomo Chemical Company, Limited, Tokyo 104-8260 (JP); Sumation Co., Ltd., Chuo-ku Tokyo 104-8260 (JP)
(72) Inventor: ANRYU, Makoto, Tsukuba-shi Ibaraki 305-0821 (JP)
(74) Representative: Duckworth, Timothy John
(86) International application number: PCT/JP2008/071997
(87) International publication number: WO 2009/069820

(57) **Abstract**

An organic electroluminescent device comprising an anode, a first layer disposed on the anode, a second layer containing a light emitting material, and a cathode, wherein the first layer is a layer formed on the anode by forming a non-treated layer containing a compound having a group reactive to a group present on the surface of the anode and subjecting the non-treated layer to a UV/ozone treatment, and the first layer has an average thickness of 10 nm or less.

## Description

### Technical Field

The present invention relates to an organic electroluminescent device and a production method thereof.

### Background Art

As the next generation display, organic electroluminescent (organic EL) displays are attracting attention. In an organic electroluminescent device used for such organic electroluminescent displays, an electrically conductive glass composed of indium oxide, zinc oxide, tin oxide, and composites thereof,e.g., indium-tin-oxide (ITO)and indium-zinc-oxide, and the like is often used as a transparent electrically conductive electrode through which light is allowed to pass and into which holes are to be injected.

An organic electroluminescent device having good hole injection efficiency obtained by laminating a layer containing poly(ethylenedioxythiophene)-polystyrenesulfonic acid (hereinafter, referred to as "PEDOT:PSS") on this type of transparent electrically conductive electrode is known (see JP2000-514590).

### Disclosure of the Invention

However, since PEDOT:PSS is a strongly acidic water-soluble compound, workability is poor and production of an organic electroluminescent device is not necessarily easy.

The present invention has an object of finding an alternate material good in workability and providing an organic electroluminescent device of which production is easy.

The present invention provides, in a first aspect, an organic electroluminescent device comprising an anode, a first layer disposed on the anode, a second layer containing a light emitting material, and a cathode, wherein the first layer is a layer formed on the anode by forming a non-treated layer containing a compound having a group reactive to a group present on the surface of the anode and subjecting the non-treated layer to a UV/ozone treatment, and the first layer has an average thickness of 10 nm or less.

The present invention provides, in a second aspect, a surface light source and a display, having the above-described organic electroluminescent device.

The present invention provides, in a third aspect, a method of producing an organic electroluminescent device comprising an anode, a first layer disposed on the anode, a second layer containing a light emitting material, and a cathode, the method comprising a step of forming a non-treated layer containing a compound having a group reactive to a group present on the surface of the anode and a step of subjecting the non-treated layer to a UV/ozone treatment to form the first layer on the anode.

### Modes for Carrying Out the Invention

### <Explanation of terms>

Terms commonly used in the present specification will be explained below. In the present specification, the term "Cₘ to Cₙ" (m and n are positive integers satisfying m<n) means that the number of carbon atoms of a group described together with this term is m to n.

Examples of the halogen atom include a fluorine atom, chlorine atom, bromine atom, iodine atom and the like.

The alkyl group means an unsubstituted alkyl group and an alkyl group substituted by a halogen atom, an amino group, a mercapto group or the like, and includes both linear alkyl groups and cyclic alkyl groups (cycloalkyl groups). The alkyl group may have a branch. The alkyl group has a number of carbon atoms of usually 1 to 20, preferably 1 to 15, more preferably about 1 to 10. Examples of the alkyl group include a methyl group, an ethyl group, a propyl group, an i-propyl group, a butyl group, an i-butyl group, a t-butyl group, a pentyl group, a hexyl group, a cyclohexyl group, a heptyl group, an octyl group, a 2-ethylhexyl group, a nonyl group, a decyl group, a 3,7-dimethyloctyl group, a lauryl group, a trifluoromethyl group, a pentafluoroethyl group, a perfluorobutyl group, a perfluorohexyl group, a perfluorooctyl group, trifluoropropyl group, a tridecafluoro-1,1,2,2-tetrahydrooctyl group, a heptadecafluoro-1,1,2,2-tetrahydrodecyl group, an aminopropyl group, an aminooctyl group, an aminodecyl group, a mercaptopropyl group, a mercaptooctyl group, a mercaptodecyl group and the like. Examples of the C₁ to C₁₂ alkyl group include a methyl group, an ethyl group, a propyl group, an i-propyl group, a butyl group, an i-butyl group, a s-butyl group, a t-butyl group, a pentyl group, an isoamyl group, a hexyl group, a cyclohexyl group, a heptyl group, an octyl group, a nonyl group, a decyl group and a dodecyl group.

The alkoxy group means an unsubstituted alkoxy group and an alkoxy group substituted by a halogen atom, an alkoxy group or the like, and include both linear alkoxy groups and cyclic alkoxy groups (cycloalkoxy groups). The alkoxy group may have a branch. The alkoxy group has a number of carbon atoms of usually 1 to 20, preferably 1 to 15, more preferably about 1 to 10. Examples of the alkoxy group include a methoxy group, an ethoxy group, a propyloxy group, an i-propyloxy group, a butoxy group, an i-butoxy group, t-butoxy group, a pentyloxy group, a hexyloxy group, cyclohexyloxy group, a heptyloxy group, an octyloxy group, a 2-ethylhexyloxy group, a nonyloxy group, decyloxy group, a 3,7-dimethyloctyloxy group, a lauryloxy group, a trifluoromethoxy group, a pentafluoroethoxy group, a perfluorobutoxy group, a perfluorohexyl group, a perfluorooctyl group, a methoxymethyloxy group, a 2-methoxyethyloxy group and the like. Examples of the C₁ to C₁₂ alkoxy group include a methoxy group, an ethoxy group, a propyloxy group, an i-propyloxy group, a butoxy group, an i-butoxy group, a t-butoxy group, a pentyloxy group, hexyloxy group, a cyclohexyloxy group, a heptyloxy group, an octyloxy group, a 2-ethylhexyloxy group, a nonyloxy group, a decyloxy group, a 3,7-dimethyloctyloxy group and a lauryloxy group.

The alkylthio group means an unsubstituted alkylthio group and an alkylthio group substituted by a halogen atom or the like, and includes both linear alkylthio groups and cyclic alkylthio groups (cycloalkylthio groups). The alkylthio group may have a branch. The alkylthio group has a number of carbon atoms of usually 1 to 20, preferably 1 to 15, more preferably about 1 to 10. Examples of the alkylthio group include a methylthio group, an ethylthio group, a propylthio group, an i-propylthio group, a butylthio group, an i-butylthio group, a t-butylthio group, pentylthio group, a hexylthio group, a cyclohexylthio group, a heptylthio group, an octylthio group, a 2-ethylhexylthio group, a nonylthio group, a decylthio group, a 3,7-dimethyloctylthio group, a laurylthio group, a trifluoromethylthio group and the like. Examples of the C₁ to C₁₂ alkylthio group include a methylthio group, a ethylthio group, a propylthio group, an i-propylthio group, a butylthio group, an i-butylthio group, a t-butylthio group, a pentylthio group, a hexylthio group, a cyclohexylthio group, a heptylthio group, an octylthio group, a 2-ethylhexylthio group, a nonylthio group, a decylthio group, a 3,7-dimethyloctylthio group and a laurylthio group.

The aryl group is an atomic group remaining after removing one hydrogen atom bonded to a carbon atom constituting an aromatic ring from an aromatic hydrocarbon, and means an unsubstituted aryl group and an aryl group substituted by a halogen atom, an alkoxy group, an alkyl group or the like. The aryl group includes also those having a condensed ring, and those having two or more independent benzene rings or condensed rings bonded via a single bond or a di-valent group, for example, an alkenylene group such as a vinylene group and the like. The aryl group has a number of carbon atoms of usually 6 to 60, preferably 7 to 48, more preferably about 7 to 30. The aryl group includes a phenyl group, a C₁ to C₁₂ alkoxyphenyl group, a C₁ to C₁₂ alkylphenyl group, a 1-naphthyl group, a 2-naphthyl group, a 1-anthracenyl group,a 2-anthracenyl group, a 9-anthracenyl group, a pentafluorophenyl group and the like, and preferable are a C₁ to C₁₂ alkoxyphenyl group and a C₁ to C₁₂ alkylphenyl group.

Examples of the C₁ to C₁₂ alkoxyphenyl group include a methoxyphenyl group, an ethoxyphenyl group, a propyloxyphenyl group, an i-propyloxyphenyl group, a butoxyphenyl group, an i-butoxyphenyl group, t-butoxyphenyl group, a pentyloxyphenyl group, a hexyloxyphenyl group, a cyclohexyloxyphenyl group, a heptyloxyphenyl group, an octyloxyphenyl group, a 2-an ethylhexyloxyphenyl group, a nonyloxyphenyl group, a decyloxyphenyl group, a 3,7-dimethyloctyloxyphenyl group, a lauryloxyphenyl group and the like.

Examples of the C₁ to C₁₂ alkylphenyl group include a methylphenyl group, an ethylphenyl group, a dimethylphenyl group, a propylphenyl group, a mesityl group, a methylethylphenyl group, an i-propylphenyl group, a butylphenyl group, an i-butylphenyl group, a t-butylphenyl group, a pentylphenyl group, an isoamylphenyl group, a hexylphenyl group, a heptylphenyl group, an octylphenyl group, a nonylphenyl group, a decylphenyl group, a dodecylphenyl group and the like.

The aryloxy group means an unsubstituted aryloxy group and an aryloxy group substituted by a halogen atom, an alkoxy group, an alkyl group or the like. The aryloxy group has a number of carbon atoms of usually 6 to 60, preferably 7 to 48, more preferably about 7 to 30. Examples thereof include a phenoxy group, a C₁ to C₁₂ alkoxyphenoxy group, a C₁ to C₁₂ alkylphenoxy group, a 1-naphthyloxy group, a 2-naphthyloxy group, a pentafluorophenyloxy group and the like, and preferable are a C₁ to C₁₂ alkoxyphenoxy group and a C₁ to C₁₂ alkylphenoxy group.

Examples of the C₁ to C₁₂ alkoxyphenoxy group include a methoxyphenoxy group, an ethoxyphenoxy group, a propyloxyphenoxy group, an i-propyloxyphenoxy group, a butoxyphenoxy group, an i-butoxyphenoxy group, a t-butoxyphenoxy group, a pentyloxyphenoxy group, a hexyloxyphenoxy group, a cyclohexyloxyphenoxy group, a heptyloxyphenoxy group, an octyloxyphenoxy group, a 2-ethylhexyloxyphenoxy group, a nonyloxyphenoxy group, a decyloxyphenoxy group, a 3,7-dimethyloctyloxyphenoxy group, a lauryloxyphenoxy group and the like.

Examples of the C₁ to C₁₂ alkylphenoxy group include a methylphenoxy group, an ethylphenoxy group, a dimethylphenoxy group, a propylphenoxy group, a 1,3,5-trimethylphenoxy group, a methylethylphenoxy group, an i-propylphenoxy group, a butylphenoxy group, an i-butylphenoxy group, a t-butylphenoxy group, pentylphenoxy group, an isoamylphenoxy group, a hexylphenoxy group, a heptylphenoxy group, an octylphenoxy group, a nonylphenoxy group, a decylphenoxy group, a dodecylphenoxy group and the like.

The arylthio group means an unsubstituted arylthio group and an arylthio group substituted by a halogen atom, an alkoxy group, an alkyl group or the like. The arylthio group has a number of carbon atoms of usually 6 to 60, preferably 7 to 48, more preferably about 7 to 30. Examples of the arylthio group include a phenylthio group, a C₁ to C₁₂ alkoxyphenylthio group, a C₁ to C₁₂ alkylphenylthio group, a 1-naphthylthio group, a 2-naphthylthio group, a pentafluorophenylthio group and the like.

The arylalkyl group means an unsubstituted arylalkyl group and an arylalkyl group substituted by a halogen atom, an alkoxy group, an alkyl group or the like. The arylalkyl group has a number of carbon atoms of usually 7 to 60, preferably 7 to 48, more preferably about 7 to 30.

Examples of the arylalkyl group include a phenyl C₁ to C₁₂ alkyl group, a C₁ to C₁₂ alkoxyphenyl C₁ to C₁₂ alkyl group, a C₁ to C₁₂ alkylphenyl C₁ to C₁₂ alkyl group, a 1-naphthyl C₁ to C₁₂ alkyl group, a 2-naphthyl C₁ to C₁₂ alkyl group and the like.

The arylalkoxy group means an unsubstituted arylalkoxy group and an arylalkoxy group substituted by a halogen atom, an alkoxy group, an alkyl group or the like. The arylalkoxy group has a number of carbon atoms of usually 7 to 60, preferably 7 to 48, more preferably about 7 to 30. Examples of the arylalkoxy group include a phenyl C₁ to C₁₂ alkoxy group, a C₁ to C₁₂ alkoxyphenyl C₁ to C₁₂ alkoxy group, a C₁ to C₁₂ alkylphenyl C₁ to C₁₂ alkoxy group, a 1-naphthyl C₁ to C₁₂ alkoxy group, a 2-naphthyl C₁ to C₁₂ alkoxy group and the like.

The arylalkylthio group means an unsubstituted arylalkylthio group and an arylalkylthio group substituted by a halogen atom, an alkoxy group, an alkyl group or the like. The arylalkylthio group has a number of carbon atoms of usually 7 to 60, preferably 7 to 48, more preferably about 7 to 30. Examples of the arylalkylthio group include a phenyl C₁ to C₁₂ alkylthio group, a C₁ to C₁₂ alkoxyphenyl C₁ to C₁₂ alkylthio group, a C₁ to C₁₂ alkylphenyl C₁ to C₁₂ alkylthio group, a 1-naphthyl C₁ to C₁₂ alkylthio group, a 2-naphthyl C₁ to C₁₂ alkylthio group and the like.

The arylalkenyl group means an unsubstituted arylalkenyl group and an arylalkenyl group substituted by a halogen atom, an alkoxy group, an alkyl group or the like. The arylalkenyl group has a number of carbon atoms of usually 8 to 60, preferably 8 to 48, more preferably about 8 to 30. Examples thereof include a phenyl C₂ to C₁₂ alkenyl group, a C₁ to C₁₂ alkoxyphenyl C₂ to C₁₂ alkenyl group, a C₁ to C₁₂ alkylphenyl C₂ to C₁₂ alkenyl group, a 1-naphthyl C₂ to C₁₂ alkenyl group, a 2-naphthyl C₂ to C₁₂ alkenyl group and the like, and preferable are a C₁ to C₁₂ alkoxyphenyl C₂ to C₁₂ alkenyl group and C₂ to C₁₂ alkylphenyl C₂ to C₁₂ alkenyl group.

Examples of the C₂ to C₁₂ alkenyl group include a vinyl group, a 1-propenyl group, a 2-propenyl group, a 1-butenyl group, a 2-butenyl group, a 1-pentenyl group, a 2-pentenyl group, a 1-hexenyl group, a 2-hexenyl group and a 1-octenyl group.

The arylalkynyl group means an unsubstituted arylalkynyl group and an arylalkynyl group substituted by a halogen atom, an alkoxy group, an alkyl group or the like. The arylalkynyl group has a number of carbon atoms of usually 8 to 60, preferably 8 to 48, more preferably about 8 to 30. Examples thereof include a phenyl C₂ to C₁₂ alkynyl group, a C₁ to C₁₂ alkoxyphenyl C₂ to C₁₂ alkynyl group, a C₁ to C₁₂ alkylphenyl C₂ to C₁₂ alkynyl group, a 1-naphthyl C₂ to C₁₂ alkynyl group, a 2-naphthyl C₂ to C₁₂ alkynyl group and the like, and preferable are a C₁ to C₁₂ alkoxyphenyl C₂ to C₁₂ alkynyl group and a C₁ to C₁₂ alkylphenyl C₂ to C₁₂ alkynyl group.

Examples of the C₂ to C₁₂ alkynyl group include an ethynyl group, a 1-propynyl group, a 2-propynyl group, 1-butynyl group, a 2-butynyl group, a 1-pentynyl group, 2-pentynyl group, a 1-hexynyl group, a 2-hexynyl group and a 1-octynyl group.

The monovalent heterocyclic group is an atomic group remaining after removing one hydrogen atom from a heterocyclic compound, and means an unsubstituted monovalent heterocyclic group and a monovalent heterocyclic group substituted by a substituent such as an alkyl group and the like. The monovalent heterocyclic group has a number of carbon atoms of usually 4 to 60, preferably 4 to 30, more preferably about 4 to 20, not including the number of carbon atoms of the substituent. Here, the heterocyclic compound includes organic compounds having a cyclic structure containing not only a carbon atom but also a hetero atom such as an oxygen atom, a sulfur atom, a nitrogen atom, a phosphorus atom, a boron atom, a silicon atom, a selenium atom, a tellurium atom, an arsenic atom and the like, as the element constituting the ring. Examples of the monovalent heterocyclic group include a thienyl group, a C₁ to C₁₂ alkylthienyl group, a pyrrolyl group, a furyl group, a pyridyl group, a C₁ to C₁₂ alkylpyridyl group, a pyridazinyl group, a pyrimidyl group, a pyrazinyl group, a triazinyl group, pyrrolidyl group, a piperidyl group, a quinolyl group and isoquinolyl group, and of them, preferable are a thienyl group, a C₁ to C₁₂ alkylthienyl group, a pyridyl group and a C₁ to C₁₂ alkylpyridyl group.

The heterocyclic thio group means a group obtained by substituting a hydrogen atom of a mercapto group by a monovalent heterocyclic group. Examples of the heterocyclic thio group include heteroarylthio groups such as a pyridylthio group, a pyridazinylthio group, a pyrimidylthio group, a pyrazinylthio group, a triazinylthio group and the like.

The amino group means an unsubstituted amino group and an amino group substituted by 1 or 2 substituents selected from an alkyl group, an aryl group,an arylalkyl group and a monovalent heterocyclic group hereinafter, referred to as substituted amino group. The substituent may further have a substituent hereinafter, referred to as secondary substituent, in some cases. The substituted amino group has a number of carbon atoms of usually 1 to 60, preferably 2 to 48, more preferably about 2 to 40, not including the number of carbon atoms of the secondary substituent. Examples of the substituted amino group include a methylamino group, a dimethylamino group, an ethylamino group, a diethylamino group, a propylamino group, a dipropylamino group, an isopropylamino group, diisopropylamino group, a butylamino group, isobutylamino group, s-butylamino group, t-butylamino group, a pentylamino group, a hexylamino group, heptylamino group, an octylamino group, a 2-ethylhexylamino group, a nonylamino group, a decylamino group, a 3,7-dimethyloctylamino group, a dodecylamino group, cyclopentylamino group, dicyclopentylamino group, a cyclohexylamino group, a dicyclohexylamino group, a ditrifluoromethylamino group, a phenylamino group, a diphenylamino group, a C₁ to C₁₂ alkoxyphenylamino group, a di (C₁ to C₁₂ alkoxyphenyl)amino group, a C₁ to C₁₂ alkylphenylamino group, di (C₁ to C₁₂ alkylphenyl)amino group, 1-naphthylamino group, a 2-naphthyl amino group, pentafluorophenylamino group, a pyridylamino group, pyridazinylamino group, a pyrimidylamino group, pyrazinylamino group, a triazinylamino group, a phenyl C₁ to C₁₂ alkylamino group, a C₁ to C₁₂ alkoxyphenyl C₁ to C₁₂ alkylamino group, a di (C₁ to C₁₂ alkoxyphenyl C₁ to C₁₂ alkyl)amino group, a C₁ to C₁₂ alkylphenyl C₁ to C₁₂ alkylamino group, a di (C₁ to C₁₂ alkylphenyl C₁ to C₁₂ alkyl)amino group, a 1-naphthyl-C₁ to C₁₂ alkylamino group and a 2-naphthyl-C₁ to C₁₂ alkylamino group.

The silyl group means an unsubstituted silyl group and a silyl group substituted by one, two or three substituents selected from an alkyl group, an aryl group, an arylalkyl group and a monovalent heterocyclic group (hereinafter, referred to as substituted silyl group). The substituent may have a secondary substituent. The substituted silyl group has a number of carbon atoms of usually 1 to 60, preferably 3 to 48, more preferably about 3 to 40, not including the number of carbon atoms of the secondary substituent. Examples of the substituted silyl group include a trimethylsilyl group, a triethylsilyl group, a tripropylsilyl group, a tri-isopropylsilyl group, a dimethylisopropylsilyl group, a diethylisopropylsilyl group, a t-butylsilyldimethylsilyl group, a pentyldimethylsilyl group, a hexyldimethylsilyl group, a heptyldimethylsilyl group, an octyldimethylsilyl group, a 2-ethylhexyldimethylsilyl group, a nonyldimethylsilyl group, a decyldimethylsilyl group, a 3,7-dimethyloctyldimethylsilyl group, a dodecyldimethylsilyl group, a phenyl C₁ to C₁₂ alkylsilyl group, a C₁ to C₁₂ alkoxyphenyl C₁ to C₁₂ alkylsilyl group, a C₁ to C₁₂ alkylphenyl C₁ to C₁₂ alkylsilyl group, a 1-naphthyl C₁ to C₁₂ alkylsilyl group, a 2-naphthyl C₁ to C₁₂ alkylsilyl group, a phenyl C₁ to C₁₂ alkyldimethylsilyl group, a triphenylsilyl group, a tri-p-xylylsilyl group, a tribenzylsilyl group, a diphenylmethylsilyl group, a t-butyldiphenylsilyl group and a dimethylphenylsilyl group.

The acyl group means an unsubstituted acyl group and an acyl group substituted by a halogen atom or the like.

The acyl group has a number of carbon atoms of usually 1 to 20, preferably 2 to 18, more preferably about 2 to 16. Examples of the acyl group include a formyl group, an acetyl group, a propionyl group, butyryl group, an isobutyryl group, a pivaloyl group, benzoyl group, a trifluoroacetyl group and a pentafluorobenzoyl group.

The acyloxy group means an unsubstituted acyloxy group and an acyloxy group substituted by a halogen atom or the like. The acyloxy group has a number of carbon atoms of usually 1 to 20, preferably 2 to 18, more preferably about 2 to 16. Examples of the acyloxy group include a formyloxy group, an acetoxy group, a propionyloxy group, a butyryloxy group, an isobutyryloxy group, a pivaloyloxy group, a benzoyloxy group, a trifluoroacetyloxy group, a pentafluorobenzoyloxy group and the like.

The imine residue means a residue obtained by removing one hydrogen atom in the structure of an imine compound having a structure of at least one of the formula: H-N=C< and the formula: -N=CH-. Examples of such an imine compound include aldimines, ketimines, and compounds obtained by substituting a hydrogen atom bonded to a nitrogen atom in an aldimine by an alkyl group, an aryl group, an arylalkyl group, an arylalkenyl group, an arylalkynyl group and the like. The imine residue has a number of carbon atoms of usually 2 to 20, preferably 2 to 18, more preferably about 2 to 16. Examples of the imine residue include groups of the general formula: -CR'=N-R" or the general formula: -N=C(R")2 wherein R' represents a hydrogen atom, an alkyl group, an aryl group, an arylalkyl group, an arylalkenyl group, an arylalkynyl group, each R" independently represents an alkyl group, an aryl group, an arylalkyl group, an arylalkenyl group or an arylalkynyl group, and when there exists two R", two R" may be mutually integrated to form a ring, as a divalent group, for example, an alkylene group having 2 to 18 carbon atoms such as an ethylene group, a trimethylene group, a tetramethylene group, a pentamethylene group, a hexamethylene group and the like. Examples of the imine residue include groups of the following structural formulae, and the like. 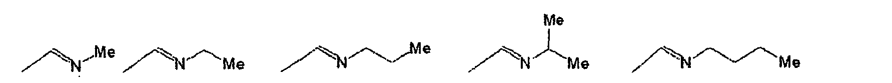 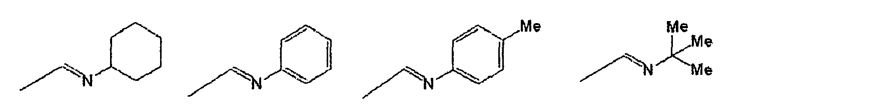 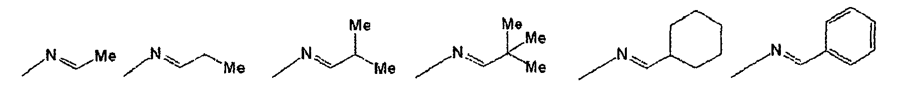 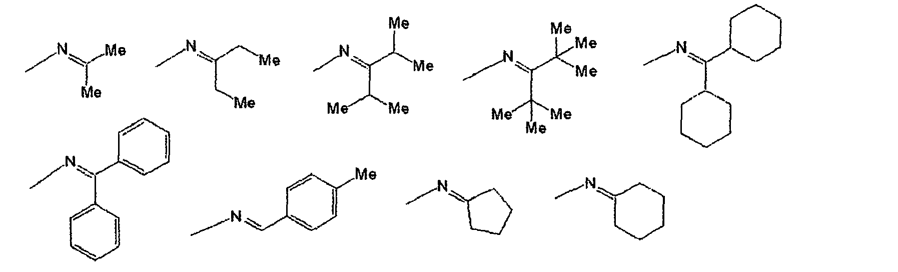 wherein Me represents a methyl group.

The amide group means an unsubstituted amide group and an amide group substituted by a halogen atom or the like.

The amide group has a number of carbon atoms of usually 2 to 20, preferably 2 to 18, more preferably about 2 to 16. Examples of the amide group include a formamide group, an acetamide group, a propioamide group, a butyroamide group, a benzamide group, a trifluoroacetamide group, a pentafluorobenzamide group, a diformamide group, a diacetamide group, a dipropioamide group, a dibutyroamide group, a dibenzamide group, a ditrifluoroacetamide group and a dipentafluorobenzamide group.

The acid imide group means a residue obtained by removing, from an acid imide, a hydrogen atom bonded to its nitrogen atom. The acid imide group has a number of carbon atoms of usually 4 to 20, preferably 4 to 18, more preferably about 4 to 16. Examples of the acid imide group include groups shown below. 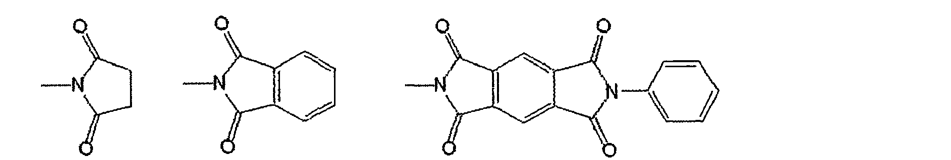 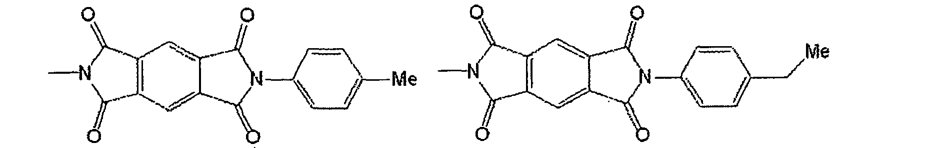 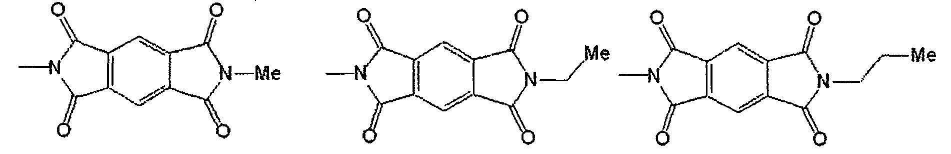 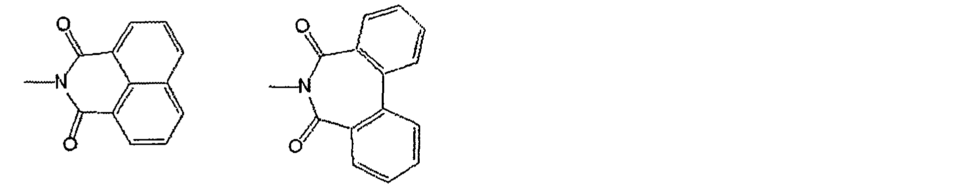 wherein Me represents a methyl group.

The carboxyl group means an unsubstituted carboxyl group and a carboxyl group substituted by a substituent such as an alkyl group, an aryl group, an arylalkyl group, a monovalent heterocyclic group and the like (hereinafter, referred to as substituted carboxyl group). The substituent may have a secondary substituent. The substituted carboxyl group has a number of carbon atoms of usually 1 to 60, preferably 2 to 48, more preferably about 2 to 45, not including the number of carbon atoms of the secondary substituent. Examples of the substituted carboxyl group include a methoxycarbonyl group, a ethoxycarbonyl group, a propoxycarbonyl group, an isopropoxycarbonyl group, a butoxycarbonyl group, an isobutoxycarbonyl group, a s-butoxycarbonyl group, a t-butoxycarbonyl group, a pentyloxycarbonyl group, a hexyloxycarbonyl group, a cyclohexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, a dodecyloxycarbonyl group, a trifluoromethoxycarbonyl group, a pentafluoroethoxycarbonyl group, a perfluorobutoxycarbonyl group, a perfluorohexyloxycarbonyl group, a perfluorooctyloxycarbonyl group, a phenoxycarbonyl group, a naphthoxycarbonyl group and a pyridyloxycarbonyl group.

### <Organic Electroluminescent Device>

### First layer

The first layer in the present invention (usually, an organic layer) is a layer disposed on the anode by forming a non-treated layer (usually, a non-treated organic layer) containing a compound having a group reactive to a group present on the surface of the anode (including an atom present on the surface of the anode. The same shall apply in the followings) and subjecting the non-treated layer to a UV/ozone treatment.

The compound having a group reactive to a group present on the surface of the anode includes coupling agents constituted of an inorganic molecule and an organic molecule, for example, a silane compound, a titanium compound, a germanium compound, a tin compound, an aluminum compound, an antimony compound, a barium compound, a beryllium compound, a bismuth compound, a boron compound, a cadmium compound, a calcium compound, a cerium compound, a chromium compound, a cobalt compound, a copper compound, europium compound, a gallium compound, an indium compound, an iridium compound, an iron compound, a lead compound, a lithium compound, a magnesium compound, a manganese compound, a molybdenum compound, a nickel compound, a palladium compound, a silver compound and the like.

The above-described compound having a group reactive to a group present on the surface of the anode (usually, an organic compound) comprises preferably at least one compound selected from the group consisting of compounds of the following formula (1) and partially hydrolyzed condensates thereof, compounds having a monovalent group of the following formula (2) and partially hydrolyzed condensates thereof, and compounds of the following formula (3) and partially hydrolyzed condensates thereof:

M¹(X)ᵥ₁(R^{a})ᵤ₋ᵥ₁ (1)

-M²(X)ᵥ₂(R^{a})ᵤ₋ᵥ₂₋₁ (2)

-[Si(X)_{w}(R^{a})_{2-w}-O]ₙ- (3)

wherein M¹ represents a metal atom belonging to the Group IV, Group V, Group VI, Group XIII or Group XV of the periodic table or a carbon atom, germanium atom, tin atom or lead atom. M² represents a metal atom belonging to Group IV, Group V, Group VI, Group XIII, Group XIV or Group XV of the periodic table. X represents a group reactive (a group having reactivity) to a group present on the surface of the anode. R^{a} represents an alkyl group, aryl group, arylalkyl group, arylalkenyl group or arylalkynyl group. The group represented by R^{a} may have a substituent. v1 represents an integer of 1 or more and u or less. v2 represents an integer of 1 or more and u-1 or less. w is 1 or 2. u represents the atomic valence of M¹ or M². When there exists a plurality of X, these may be the same or different. When there exists a plurality of R^{a}, these may be the same or different. n represents the degree of polymerization., from the standpoint of a coating property.

The compound having a group reactive to a group present on the surface of the anode comprises, preferably, at least one compound selected from the group consisting of compounds having a monovalent group of formula (2) in which M² is a silicon atom and partially hydrolyzed condensates thereof, and compounds of formula (3) and partially hydrolyzed condensates thereof; or at least one compound selected from the group consisting of compounds of formula (1) in which M¹ is a titanium atom and partially hydrolyzed condensates thereof, and compounds having a monovalent group of formula (2) in which M² is a titanium atom and partially hydrolyzed condensates thereof. The compounds having a group reactive to a group present on the surface of the anode may be used singly or in combination of two or more.

The non-treated layer may contain a compound having a hole transporting ability, and the like, in addition to the compound having a group reactive to a group present on the surface of the anode. These optional components may be used singly or in combination of two or more.

The non-treated layer has a thickness of usually 0.1 to 10 nm, preferably 1.0 to 10 nm.

The first layer has an average thickness of 10 nm or less, and from the standpoint of hole injection and transporting properties, preferably 0.1 to 10 nm, more preferably 1.0 to 5.0 nm, particularly preferably 1.5 to 4.5 nm. In contrast, when the average thickness of the first layer is over 10 nm, hole injection from an anode is not carried out sufficiently, the driving voltage increases, and durability lowers, in some cases.

In formula (1), the group X reactive to a group present on the surface of the anode can be selected depending on a group or atom present on the surface of the anode. When the anode is a metal or its oxide or sulfide, examples of X include a hydroxyl group, a carboxyl group, an acyl group, an acyloxy group,a halocarbonyl group (meaning a group of the formula: - C(O)-Y ,wherein Y represents a halogen atom, and a group of the formula: -C(O)-Cl and a group of the formula: -C(O)-Br are preferable.), a halogen atom, an alkoxy group, an aryloxy group, an arylalkoxy group, a phosphoric acid group (group of the formula: (HO)₂P(O)-O-), a phosphate ester group (group of the formula: (R¹O)₂P(O)-O- or the formula (R¹O)(HO)P(O)-O-, ,wherein R¹ represents an alkyl group, an aryl group, an arylalkyl group, an arylalkenyl group or an arylalkynyl group.), a phosphorous acid group (group of the formula: (HO)₂P-O-), a phosphite ester group (group of the formula: (R¹O)₂P-O- or the formula: (R¹O)(HO)P-O-,wherein R¹ is as defined above.), a mercapto group, an alkylthio group, an arylthio group, an arylalkylthio group, a heterocyclic thio group, an amino group and the like. By reaction of X with a group or atom present on the surface of the anode, a bond such as a covalent bond, coordinate bond, ion bond and the like is formed between a compound of formula (1) or partially hydrolyzed condensate thereof and the anode. As the anode, a thin membrane of an electrically conductive inorganic oxide or metal is generally used, and its surface often have a hydroxyl group, thus, X is preferably a group or atom capable of reacting with the hydroxyl group, for example, a halogen atom, alkoxy group, phosphoric acid group, amino group, hydroxyl group or the like.

X may be one which reacts directly with a group or atom present on the surface of the anode, and in addition, may also be one which reacts indirectly via other substance, further, may be one which reacts directly and reacts indirectly simultaneously. When there exists a plurality of X, these may be the same or different.

In formula (1), M¹ represents a metal atom belonging to Group IV, Group V, Group VI, Group XIII or Group XV of the periodic table or a carbon atom, germanium atom, tin atom, or lead atom. M¹ includes metal atoms belonging to Group IV such as a titanium atom, a zirconium atom, a hafnium atom and the like; metal atoms belonging to Group V such as a vanadium atom, a niobium atom, a tantalum atom and the like; metal atoms belonging to Group VI such as a chromium atom, a molybdenum atom, a tungsten atom and the like; metal atoms belonging to Group XIII such as a boron atom, an aluminum atom, a gallium atom, an indium atom, a thallium atom and the like; metal atoms belonging to Group XV such as a phosphorus atom, an arsenic atom, an antimony atom, a bismuth atom and the like; and a germanium atom, a tin atom, a lead atom and the like, preferably a tin atom, a titanium atom, a zirconium atom, an aluminum atom, a niobium atom, a boron atom and a phosphorus atom, more preferably a zirconium atom, an aluminum atom, a boron atom, a titanium atom and a phosphorus atom, further preferably a titanium atom and a phosphorus atom.

In the formula (1), each R^{a} represents independently an alkyl group, an aryl group, an arylalkyl group, an arylalkenyl group or an arylalkynyl group, preferably an alkyl group, an aryl group or an arylalkyl group. The group represented by R^{a} may have a substituent. When there exists a plurality of R^{a}, these may be the same or different.

In the formula (1), u represents the valence of M¹ or M². When M¹ or M² represents, for example, a silicon atom, a titanium atom, a zirconium atom or the like, u is 4, and when M¹ or M² represents a boron atom, an aluminum atom or the like, u is 3.

In formula (1), v1 represents an integer of 1 or more and u or less, preferably an integer of 2 or more, more preferably an integer of 3 or more.

In a preferable embodiment of the present invention, the reactive group present on the surface of the anode is a hydroxyl group, and M¹ in formula (1) represents a titanium atom. X in formula (1) represents preferably a halogen atom, alkoxy group, phosphoric acid group or amino group. When u-v≥1, R^{a} represents preferably an alkyl group or aryl group.

The compound of formula (1) and partially hydrolyzed condensates thereof include titanium coupling agents such as propyltrimethoxytitanium, octyltrimethoxytitanium, aminopropyltrimethoxytitanium, aminodecyltrimethoxytitanium, mercaptopropyltrimethoxytitanium, mercaptooctyltrimethoxytitanium, aminopropyltriethoxytitanium, mercaptopropyltriethoxytitanium, mercaptodecyltriethoxytitanium, propyltrichlorotitanium, octyltrichlorotitanium, decyltrichlorotitanium, aminopropyltrichlorotitanium, mercaptopropyltrichlorotitanium, mercaptooctyltrichlorotitanium, heptadecafluoro-1,1,2,2-tetrahydrodecyltriethoxytitanium, heptadecafluoro-1,1,2,2-tetrahydrodecyltrichlorotitanium, titanium ethoxide, titanium isobutoxide, titanium isopropoxide, titanium methoxide and the like, and partially hydrolyzed condensates thereof and the like; butylchlorodihydroxytin, butyltrichlorotin, diallyldibutyltin, dibutyldiacetoxytin, dibutyldichlorotin, dibutyldibromotin, dibutyldimethoxytin, dimethyldichlorotin, dioctyldichlorotin, diphenyldichlorotin, methyltrichlorotin, phenyltrichlorotin, aluminum ethoxide, aluminum isopropoxide, aluminum butoxide, tetrabutoxygermane, tetraethoxygermane, tetramethoxygermane, hafnium butoxide, hafnium ethoxide, indium methoxy ethoxide, niobium butoxide, niobium ethoxide, zirconium butoxide, zirconium ethoxide, zirconium propoxide and the like. The partially hydrolyzed condensate of the compound of formula (1) has a molecular weight of usually 100 to 1000000.

In formula (2), M² represents a metal atom belonging to Group IV, Group V, Group VI, Group XIII, Group XIV or Group XV of the periodic table. M² includes metal atoms belonging toGroup VI such as a titanium atom, a zirconium atom, a hafnium atom and the like; metal atoms belonging toGroup V such as a vanadium atom, a niobium atom, a tantalum atom and the like; metal atoms belonging to Group VI such as a chromium atom, a molybdenum atom, a tungsten atom and the like; metal atoms belonging to Group XIII such as a boron atom, an aluminum atom, a gallium atom, an indium atom, a thallium atom and the like; metal atoms belonging toGroup XIV such as a silicon atom, a germanium atom, a tin atom, a lead atom and the like; metal atoms belonging to Group XV such as a phosphorus atom, an arsenic atom, an antimony atom, a bismuth atom and the like, preferably a silicon atom, a tin atom, a titanium atom, a zirconium atom, an aluminum atom, a niobium atom, a boron atom and a phosphorus atom, more preferably a silicon atom, a zirconium atom, an aluminum atom, a boron atom, a titanium atom and a phosphorus atom, further preferably a silicon atom, a titanium atom and a phosphorus atom.

In the formula (2), X, R^{a} and u have the same meanings as defined above.

In formula (2), v2 represents an integer of 1 or more and u-1 or less, preferably an integer of 2 or more.

The compound having a monovalent group of formula (2) or its partially hydrolyzed condensate preferably carries a monovalent group of formula (2) on its side chain. In the compound having a monovalent group of formula (2) and partially hydrolyzed condensates, the number of the monovalent group of formula (2) may be one or two or more.

In the compound having a monovalent group of formula (2) and partially hydrolyzed condensates, the total weight of M² is preferably 10% or more, more preferably 15% or more, further preferably 20% or more.

When the compound having a monovalent group of formula (2) or its partially hydrolyzed condensate carries the monovalent group of formula (2) on its side chain, examples of the repeating unit constituting the main chain include an alkylene group, an arylene group, a divalent heterocyclic group and amine residue.

A copolymer composed of a repeating unit having a monovalent group of formula (2) on its side chain and a repeating unit having no monovalent group of formula (2) on its side chain may also be permissible, and the proportion of the repeating unit having a monovalent group of formula (2) on its side chain is preferably 5 mol% or more, more preferably 10 mol% or more, further preferably 20 mol% or more, with respect to all repeating units in the copolymer.

Examples of the compound having a monovalent group of formula (2) and partially hydrolyzed condensates thereof include the following structures. 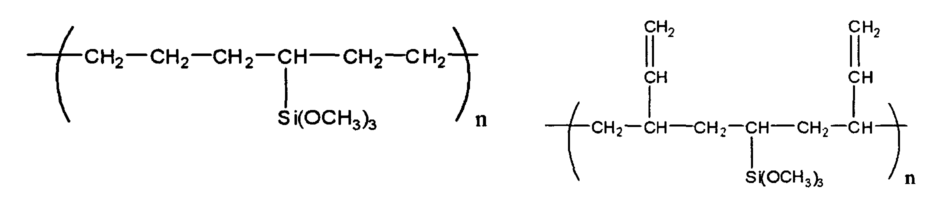 wherein n represents the degree of polymerization.

The compound having a monovalent group of formula (2) or its partially hydrolyzed condensate has a molecular weight of usually 100 to 1000000.

The compound having a monovalent group of formula (2) and partially hydrolyzed condensates thereof may be used singly or in combination of two or more.

In formula (3), X and R^{a} have the same meaning as described above.

In formula (3), w is 1 or 2.

In formula (3), n represents the degree of polymerization, and it is usually an integer of 2 to 100000, preferably an integer of 10 to 10000.

The compound of formula (3) and partially hydrolyzed condensates thereof include polydiethoxysiloxane, polydibutoxysiloxane, polydiethyl titanate, polydibutyl titanate, and diethoxysiloxane-ethyl titanate copolymer.

The compound of formula (3) and its partially hydrolyzed condensate has a molecular weight of usually 100 to 1000000.

The compound of formula (3) and partially hydrolyzed condensates thereof may be used singly or in combination of two or more.

The compound having a group reactive to a group present on the surface of the anode (usually, an organic compound) comprises, preferably, at least one compound selected from the group consisting of compounds of the following formula (1') and partially hydrolyzed condensates thereof:

Si(X)ᵥ₁(R^{a})ᵤ₋ᵥ₁ (1')

wherein X, R^{a}, v1 and u have the same meaning as described above,
from the standpoint of reactivity with a compound constituting the anode.

The compound of formula (1') includes acetoxypropyltrichlorosilane, acetoxypropyltrimethoxysilane, adamantylethyltrichlorosilane, allyltrichlorosilane, allyltrimethoxysilane, 3-aminopropylmethyldiethoxysilane, 3-aminopropyltriethoxysilane, 3-aminopropyltrimethoxysilane, 3-aminopropyltris(methoxyethoxyethoxy)silane, benzyltrichlorosilane, benzyltriethoxysilane, bis(trimethoxysilyl)ethane, 3-bromopropyltrichlorosilane, 3-bromopropyltriethoxysilane, 3-bromopropyltrimethoxysilane, 3-butenyltriethoxysilane, n-butyltrimethoxysilane, 2-chloroethyltrichlorosilane, 2-chloroethyltriethoxysilane, ((chloromethyl)phenylethyl)trimethoxysilane, (p-chloromethyl)phenyltrimethoxysilane, chlorophenyltriethoxysilane, 3-chloropropylmethyldimethoxysilane, 3-chloropropyltrimethoxysilane, (dichloromethyl)dimethylchlorosilane, (dichloromethyl)methyldichlorosilane, 2-(3,4-epoxycyclohexyl)ethyltrimethoxysilane, (3-glycidoxypropyl)trimethoxysilane, (3-glycidoxypropyl)methyldimethoxysilane, (heptadecafluoro-1,1,2,2-tetrahydrodecyl)triethoxysilane, 3-(heptafluoroisopropoxy)propyltriethoxysilane, hexamethyldisilazane, 3-isocyanate propyltriethoxysilane, 3-mercaptopropyltrimethoxysilane, methacryloxypropyltrimethoxysilane, methyltriethoxysilane, n-octadecyltrichlorosilane, n-octadecyltrichlorosilane, n-octyltriethoxysilane, pentafluoropropylpropyltrichlorosilane, pentafluoropropylpropyltrimethoxysilane, phenetyltrimethoxysilane, phenoxytrichlorosilane, N-phenylaminopropyltrimethoxysilane, phenyltriethoxysilane, phenyltrimethoxysilane, tetra-n-butoxysilane, tetraethoxysilane, 3-thiocyanate propyltriethoxysilane, (tridecafluoro-1,1,2,2-tetrahydrooctyl)triethoxysilane, (tridecafluoro-1,1,2,2-tetrahydrooctyl)methyldichlorosilane, vinyltrichlorosilane, vinyltriethoxysilane, vinyltrimethoxysilane and the like.

As the partially hydrolyzed condensate of the compound of formula (1'), partially hydrolyzed condensates of the above-listed compounds, and the like, are mentioned.

The compound of formula (1') and partially hydrolyzed condensates thereof may be used singly or in combination of two or more.

As the method of forming a non-treated layer containing a compound having a group reactive to a group present on the surface of the anode, there is mentioned a method in which the compound is dissolved or dispersed in a solvent, the anode is immersed in the resultant solution and the group present on the surface of the anode and a hydrophilic group in the compound (corresponding to X in formulae (1) to (3), (1')) are allowed to react. Thereafter, the unreacted compound may be removed by taking the anode out of the solution, and washing the anode with a solvent which dissolves the compound. In dissolving or dispersing the compound in a solvent, the hydrophilic group in the compound reacts chemically with the solvent to convert into a different group, then, the reaction with the anode may be performed. As this reaction, a hydrolysis reaction and the like are mentioned.

Examples of the solvent for dissolving or dispersing the compound include chlorine-based solvents such as chloroform, methylene chloride, 1,2-dichloroethane,1,1,2-trichloroethane,chlorobenzene, o-dichlorobenzene and the like; ether solvents such as tetrahydrofuran, dioxane and the like; aromatic hydrocarbon solvents such as toluene, xylene and the like; aliphatic hydrocarbon solvents such as cyclohexane, methylcyclohexane, n-pentane, n-hexane, n-heptane, n-octane, n-nonane, n-decane and the like; ketones solvents such as acetone, methyl ethyl ketone, cyclohexanone and the like; ester solvents such as ethyl acetate, butyl acetate, ethyl cellosolve acetate and the like; polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol and the like, and derivatives thereof; alcohol solvents such as methanol, ethanol, propanol, isopropanol, cyclohexanol and the like; sulfoxide solvents such as dimethyl sulfoxide and the like; water, and the like. The solvents may be used singly or in combination of two or more.

The concentration of the compound in the solution obtained by dissolving or dispersing the compound in a solvent is not limited. In the case of use of an immersion method, when the concentration is too low, there occurs an undesirable case of needing a longer period of time for the reaction of the compound and the anode, and when the concentration is too high, there occurs an undesirable case of lowering of film formability due to mutual coagulation of the molecules of the compound. Therefore, in the case of use of an immersion, the concentration is preferably 0.01 to 100 mmol/l. In the case of use of a spin coat method, when the concentration is too low, there occurs a difficulty in obtaining a uniform thin membrane, and when the concentration is too high, there occurs a difficulty in injection of charge for forming a thick membrane. Therefore, in the case of use of a spin coat method, the concentration is preferably 0.001 to 10 mmol/l.

For forming a thin membrane from a solution, coating methods such as a spin coat method, a casting method, a microgravure coat method, a gravure coat method, a bar coat method, a roll coat method, a wire bar coat method, a dip coat method, a spray coat method, a screen printing method, a flexo printing method, an offset printing method, an inkjet printing method, a nozzle coat method, a capillary coat method and the like can be used. The concentration of a solution for forming a thin membrane of suitable thickness varies depending on the coating method, thus, it is necessary to adjust the concentration appropriately.

Next, the UV/ozone treatment of non-treated layer will be explained.

"UV/ozone treatment" means to irradiate the non-treated layer with UV (ultraviolet ray), to change oxygen in air into ozone, and to modify the non-treated layer with the ozone and ultraviolet ray. The UV light source may be one which is capable of converting oxygen into ozone by UV irradiation.

As the UV light source, for example, a low pressure mercury lamp is mentioned. The low pressure mercury lamp generates UV rays having a wavelength of 185 nm and 254 nm, and the 185 nm beam is capable of converting oxygen into ozone. Because of strong oxidizability caused of a synergistic effect of UV and ozone, the surface of the non-treated layer can be modified, thereby promoting hole injection. The illuminance in irradiation varies depending on the light source to be used, and in general, those of tens to hundreds of mW/cm² are used. The illuminance can be changed by light condensing and diffusion. The irradiation time varies depending on the illuminance of the light source and the kind of the non-treated layer, and usually is 1 minute to 24 hours. The treatment temperature is usually 10 to 200°C. The UV radiation dose (namely, ultraviolet dose)(J/cm²) is usually 1 J/cm² or more, preferably 1 to 100000 J/cm² more preferably 10 to 100000 J/cm², further preferably 100 to 100000 J/cm², particularly preferably 1000 to 100000 J/cm²_{.}

### Second layer

The second layer (usually, an organic layer) is obtained, for example, by co-deposition of a light emitting material and the like, and film formation from a solution. The light emitting materials may be used singly or in combination of two or more.

Though the second layer is usually a light emitting layer, one molecule or two or more molecules may have a function of transporting holes, a function of transporting electrons, a function of recombination, a function of light emission, and the like.

As the light emitting material, fluorescent materials or triplet light emitting materials described in "Organic EL Display" (Shizuo Tokito, Chihaya Adachi, Hideyuki Murata, joint authorship, Ohmsha Ltd., 2004, first edition first printed publication) p. 17 to 48, p. 83 to 99, p. 101 to 120, can be used. Examples of fluorescent materials of low molecular weight include naphthalene derivatives, anthracene and derivatives thereof, perylene and derivatives thereof, dyes such as a polymethine dye, xanthene dye, coumarin dye, cyanine dye and the like; metal complexes of 8-hydroxyquinoline, metal complexes of 8-hydroxyquinoline derivatives; aromatic amines, tetraphenylcyclopentadiene and derivatives thereof, tetraphenylbutadiene and derivatives thereof, and the like, and more specifically, those described in JP-A No. 57-51781 and JP-A No. 59-194393, and the like can be used. In addition, exemplified as the light emitting material are, for example, polyfluorene, derivatives and copolymers thereof, polyarylene, derivatives and copolymers thereof, polyarylenevinylene, derivatives and copolymers thereof, and (co)polymers of aromatic amines and derivatives thereof, disclosed in WO 99/13692, WO 99/48160, GB 2340304A, WO 00/53656, WO 01/19834, WO 00/55927, GB 2348316, WO 00/46321, WO 00/06665, WO 99/54943, WO 99/54385, US 5777070, WO 98/06773, WO 97/05184, WO 00/35987, WO 00/53655, WO 01/34722, WO 99/24526, WO 00/22027, WO 00/22026, WO 98/27136, US 573636, WO 98/21262, US 5741921, WO 97/09394, WO 96/29356, WO 96/10617, EP 0707020, WO 95/07955, JP-A No. 2001-181618, JP-A No. 2001-123156, JP-A No. 2001-3045, JP-A No. 2000-351967, JP-A No. 2000-303066, JP-A No. 2000-299189, JP-A No. 2000-252065, JP-A No. 2000-136379, JP-A No. 2000-104057, JP-A No. 2000-80167, JP-A No. 10-324870, JP-A No. 10-114891, JP-A No. 9-111233, JP-A No. 9-45478 and the like.

Examples of the triplet light emitting material include triplet light emitting complexes such as compounds containing iridium as a center metal: Ir(ppy)₃, Btp₂ Ir(acac), compounds containing platinum as a center metal: PtOEP, compounds containing europium as a center metal: Eu(TTA)₃phen, and the like.

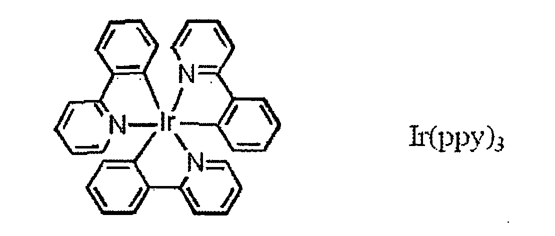

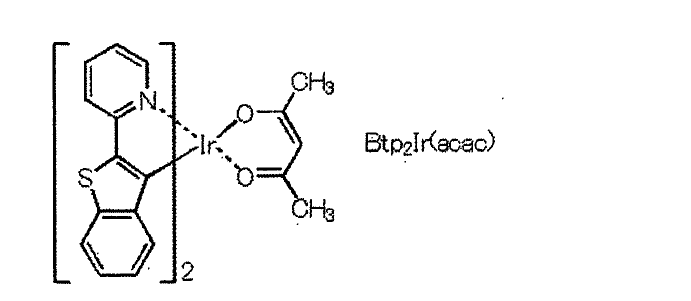

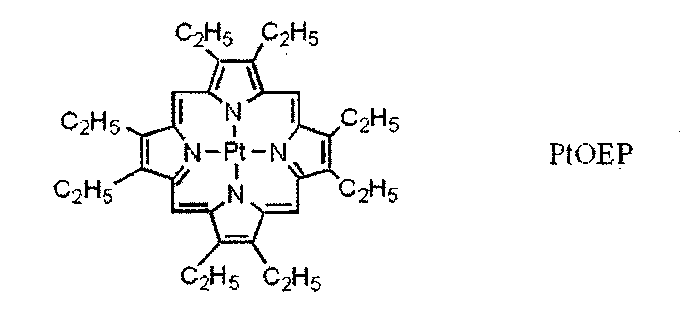

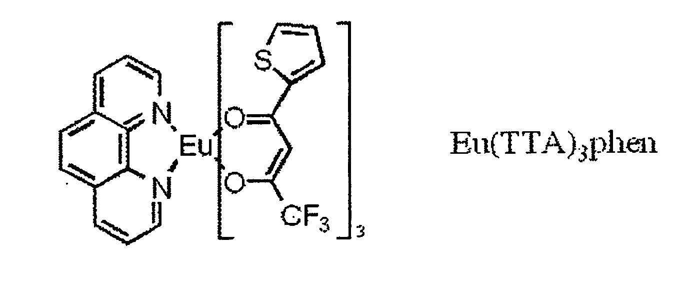

As the triplet light emitting complex, further mentioned are those described in Nature, (1998), 395, 151, Appl. Phys. Lett. (1999), 75(1), 4, Proc. SPIE-Int. Soc. Opt. Eng. (2001), 4105 (Organic Light-Emitting Materials and Devices IV), 119, J. Am. Chem. Soc., (2001), 123, 4304, Appl. Phys. Lett., (1997), 71(18), 2596, Syn. Met., (1998), 94(1), 103, Syn. Met., (1999), 99(2), 1361, Adv. Mater., (1999), 11(10), 852, Jpn. J. Appl. Phys., 34, 1883 (1995), and the like.

The light emitting material may be a polymer compound, and for example, may be any of alternative copolymer, random polymer, block polymer or graft copolymer, and may also be a polymer compound having an intermediate structure between them, for example, a random copolymer having a blocking property. As the light emitting material, a random copolymer having a blocking property, a block copolymer or graft copolymer is more preferable than a complete random copolymer, since a higher charge transporting performance is manifested, thus, higher light emission efficiency, driving at lower voltage and longer life can be realized. Polymer compounds having branching in the main chain and thus having three or more end parts, and so-called dendrimers, are also included in the light emitting material.

As the light emitting material, a polymer compound having a repeating unit of the following formula (4) and a polymer compound having a repeating unit of the following formula (7) are preferable, and a polymer compound having a repeating unit of the following formula (4) is more preferable. As the light emitting material, also a polymer compound having a repeating unit of the following formula (4) and a repeating unit of the following formula (7) is preferable. This polymer compound has a polystyrene-equivalent number average molecular weight of usually about 1×10³ to 1×10⁸, preferably 5×10³ to 1×10⁷, more preferably 1×10⁴ to 5×10⁶.

-[Ar⁵-(L¹)ₖ]- (4)

wherein Ar⁵ represents an arylene group, a di-valent heterocyclic group or a di-valent group having a metal complex structure, L¹ represents -CR¹⁵=CR¹⁶- or -C=C-, and R¹⁵ and R¹⁶ represent each independently a hydrogen atom, an alkyl group, an aryl group, a monovalent heterocyclic group or a cyano group. k is an integer of 0 to 2, preferably 0 or 1. When there exists a plurality of L¹, these may be the same or different. 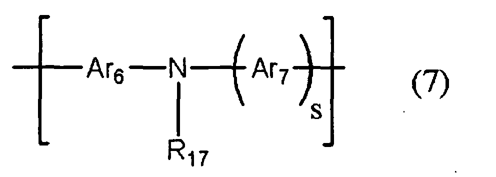 wherein Ar₆ and Ar₇ represent each independently an arylene group or a di-valent heterocyclic group. s is an integer of 1 to 4, preferably 1 or 2. R₁₇ represents an alkyl group, an aryl group, a monovalent heterocyclic group, a group of the following formula (8) or a group of the following formula (9). When R₁₇ represents an aryl group or a monovalent heterocyclic group, the aryl group and the monovalent heterocyclic group may have a substituent such as an alkyl group, an alkoxy group, an alkylthio group, a substituted silyl group, a substituted amino group, an aryl group, aryloxy group, an arylalkyl group, an arylalkoxy group, an arylalkenyl group, an arylalkynyl group, a monovalent heterocyclic group and the like. 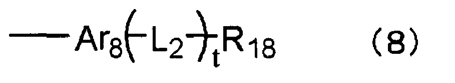 here, Ar₈ represents an arylene group or a di-valent heterocyclic group. R₁₈ represents a hydrogen atom, an alkyl group, an aryl group or a monovalent heterocyclic group. L₂ represents -CR₁₉=CR₂₀- or -C≡C-. R₁₉ and R₂₀ represent each independently a hydrogen atom, an alkyl group, an aryl group, a monovalent heterocyclic group or a cyano group. t is an integer of 0 to 2, preferably 0 or 1. When R₁₈, R₁₉ and R₂₀ represent an aryl group or a monovalent heterocyclic group, the aryl group and the monovalent heterocyclic group may have a substituent such as an alkyl group, an alkoxy group, alkylthio group, a substituted silyl group, a substituted amino group, an aryl group, an aryloxy group, an arylalkyl group, an arylalkoxy group, an arylalkenyl group, an arylalkynyl group, a monovalent heterocyclic group and the like. 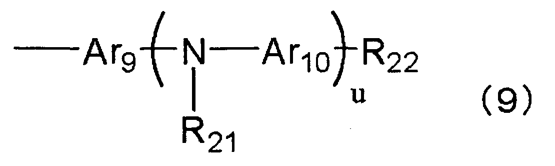 here, Ar₉ and Ar₁₀ represent each independently an arylene group or a di-valent heterocyclic group. u is an integer of 1 to 4, preferably 1 or 2. R₂₁ represents an alkyl group, an aryl group or a monovalent heterocyclic group. R₂₂ represents a hydrogen atom, an alkyl group, an aryl group or a monovalent heterocyclic group. When R₂₁ and R₂₂ represent an aryl group or monovalent heterocyclic group, the aryl group and the monovalent heterocyclic group may have a substituent such as an alkyl group, an alkoxy group, an alkylthio group, a substituted silyl group, a substituted amino group, an aryl group, aryloxy group, an arylalkyl group, an arylalkoxy group, an arylalkenyl group, an arylalkynyl group, a monovalent heterocyclic group and the like.).

The Ar₅ to Ar₁₀ may have a substituent such as an alkyl group, an alkoxy group, an alkylthio group, a substituted silyl group, a substituted amino group, an aryl group, an aryloxy group, an arylalkyl group, an arylalkoxy group, an arylalkenyl group, an arylalkynyl group, a monovalent heterocyclic group and the like.

In formulae (4), (7) to (9), the arylene group is an atomic group remaining after removing two hydrogen atoms bonded to a carbon atom constituting an aromatic ring from an aromatic hydrocarbon, and means an unsubstituted arylene group and substituted arylene group. The arylene group includes also those having a condensed ring, and those having two or more independent benzene rings or condensed rings bonded via a single bond or a di-valent organic group, for example, an alkenylene group such as a vinylene group and the like. As the substitution atom and substituent on the substituted arylene group, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a monovalent heterocyclic group, a heterocyclic thio group, an amino group, a silyl group, an acyl group, an acyloxy group, an imine residue, an amide group, an acid imide group, a carboxyl group, a cyano group and a nitro group are preferable, from the standpoint of solubility, fluorescent property, easiness of synthesis, property when made into a device, and the like.

As the arylene group in formulae (4), (7) to (9), exemplified are phenylene groups (for example, the following formulae 1 to 3), naphthalene-diyl groups (the following formulae 4 to 13), anthracene-diyl groups (the following formulae 14 to 19), biphenyl-diyl groups (the following formulae 20 to 25), terphenyl-diyl groups (the following formulae 26 to 28), condensed ring compound groups (the following formulae 29 to 35), fluorene-diyl groups (the following formulae

36 to 38), indenofluorene-diyl groups (the following formulae 38A, 38B), stilbene-diyl groups (the following formulae A to D), distilbene-diyl groups (the following formulae E, F) and the like, and a phenylene group, biphenyl-diyl group, fluorene-diyl group and stilbene-diyl group are preferable.

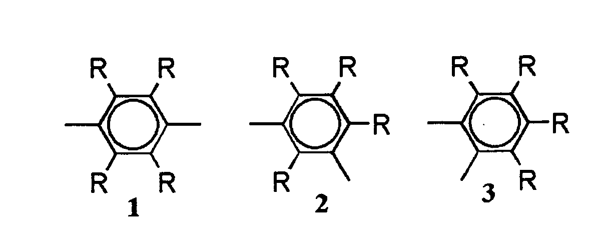

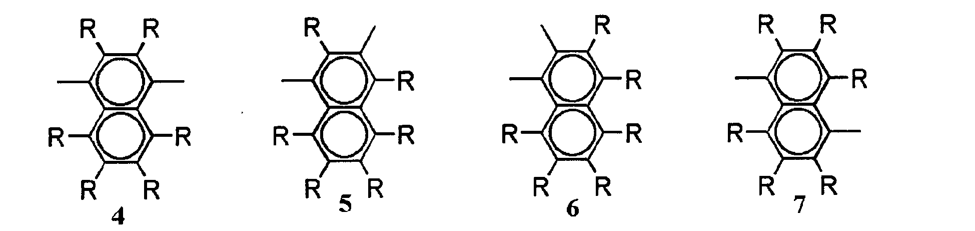

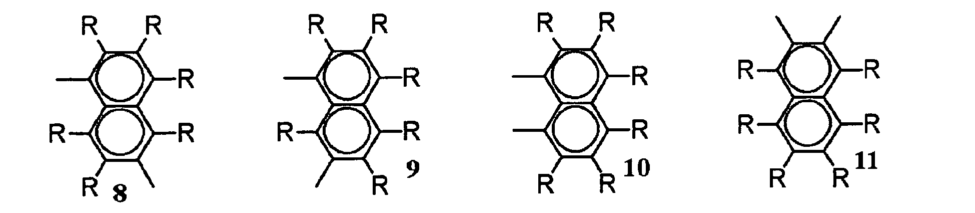

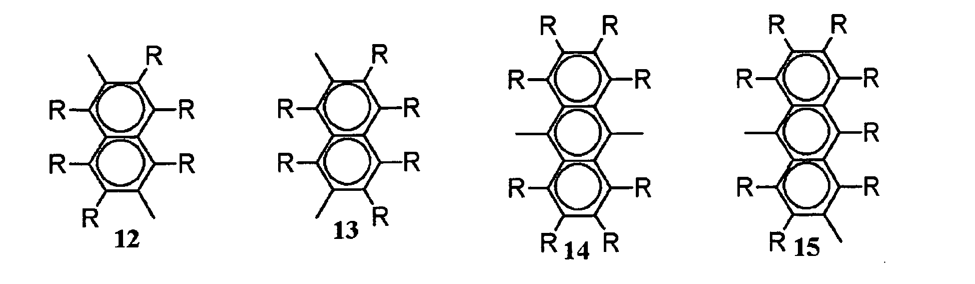

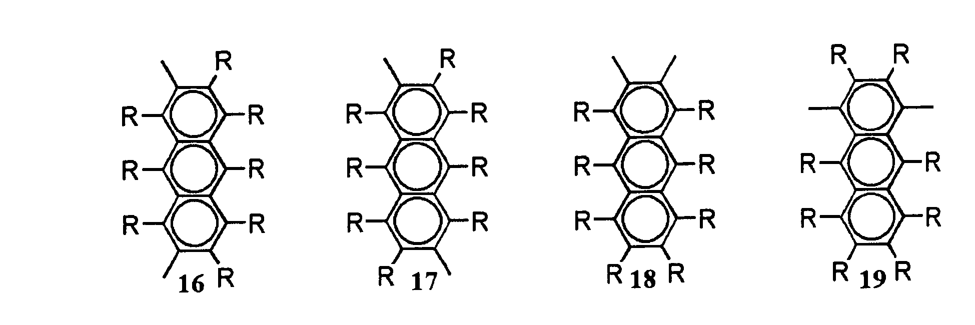

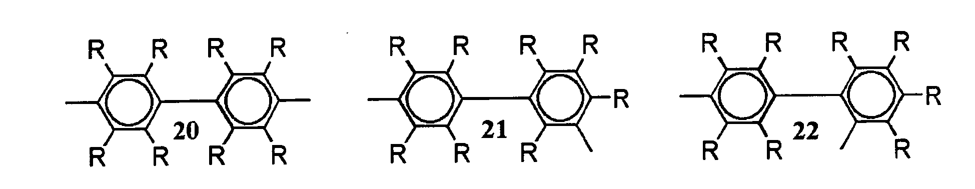

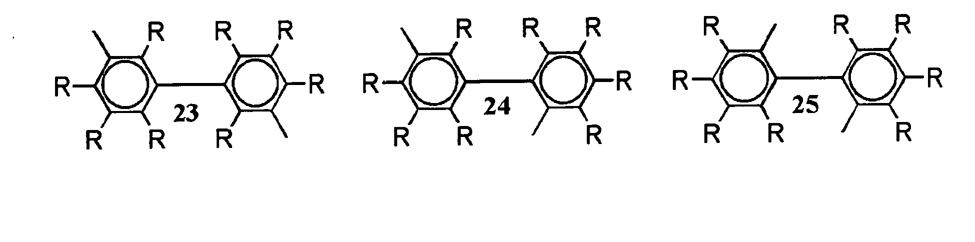

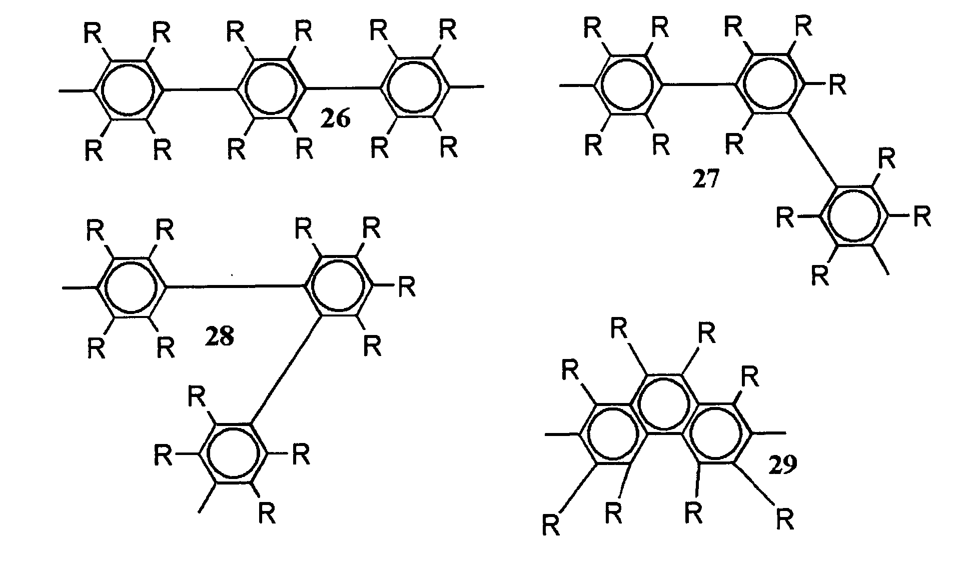

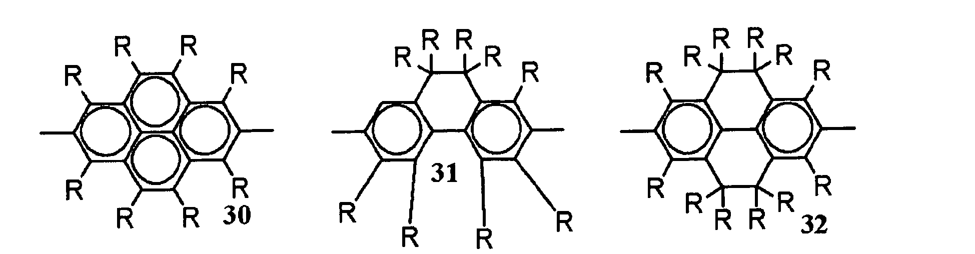

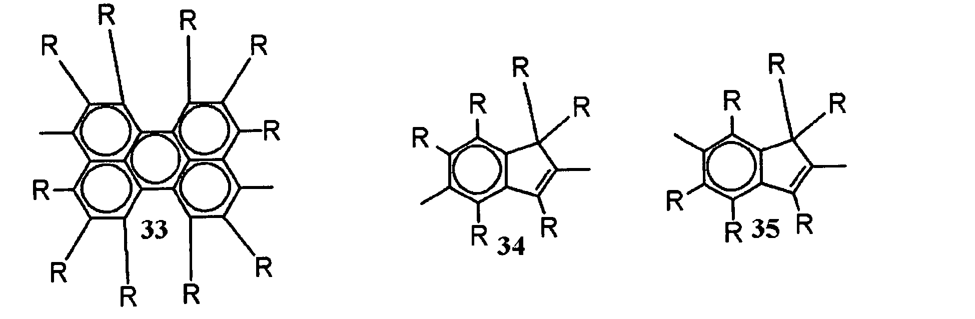

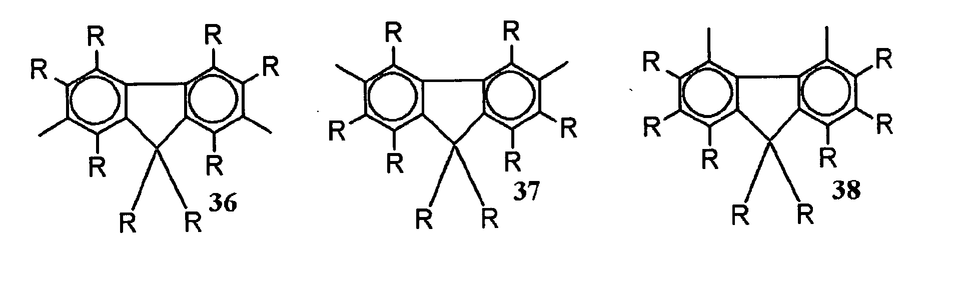

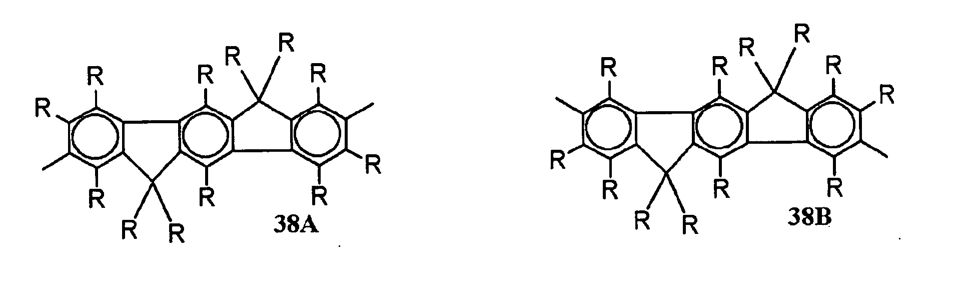

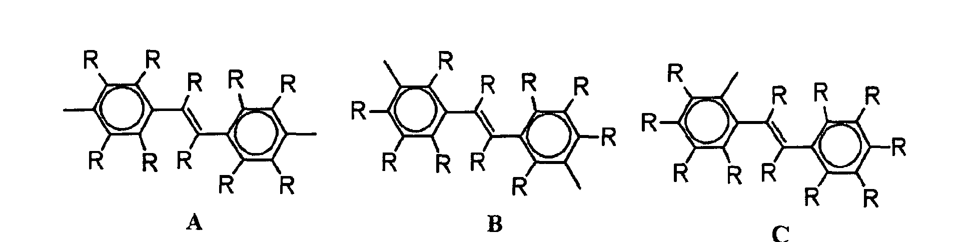

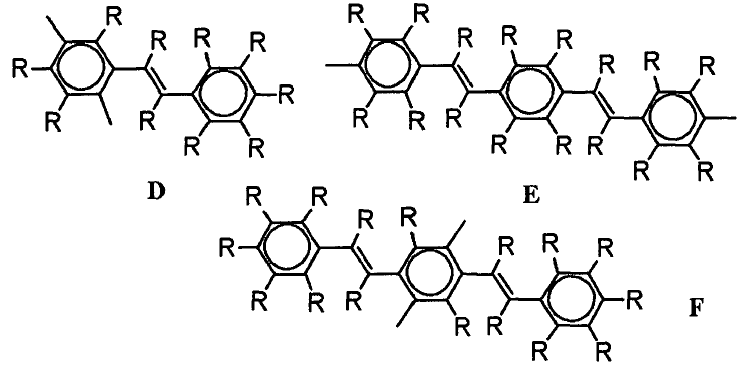

In formulae (4), (7) to (9), the di-valent heterocyclic group means an atomic group remaining after removal of two hydrogen atoms from a heterocyclic compound. The di-valent heterocyclic group may have a substituent. The heterocyclic compound means an organic compound having a cyclic structure in which elements constituting the ring include not only a carbon atom, but also a hetero atom such as an oxygen atom, a sulfur atom, a nitrogen atom, a phosphorus atom, a boron atom, an arsenic atom and the like contained in the ring. The substituent which may be carried on the di-valent heterocyclic group includes an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a silyloxy group, a substituted silyloxy group, a halogen atom, an acyl group, an acyloxy group, an imino group, an amide group, an imide group, a mono-valent heterocyclic group, a carboxyl group, a substituted carboxyl group, a cyano group and the like, preferably an alkyl group, an alkoxy group, an alkylthio group, an aryl group, an aryloxy group, an arylthio group, a substituted amino group, a substituted silyl group, a substituted silyloxy group and a mono-valent heterocyclic group. The number of carbon atoms of the unsubstituted di-valent heterocyclic group is usually about 3 to 60.

Examples of the di-valent heterocyclic group include the following groups.

Di-valent heterocyclic groups containing a nitrogen atom as a hetero atom: pyridine-diyl groups (the following formulae 39 to 44), diazaphenylene groups (the following formulae 45 to 48), quinolinediyl groups (the following formulae 49 to 63), quinoxalinediyl groups (the following formulae 64 to 68), acridinediyl groups (the following formulae 69 to 72), bipyridyldiyl groups (the following formulae 73 to 75), phenanthrolinediyl group (the following formulae 76 to 78), and the like.

Groups containing a silicon atom, nitrogen atom, sulfur atom, selenium atom, boron atom and the like as a hetero atom and having a fluorene structure (the following formulae 79 to 93, G to I).

Groups containing a silicon atom, nitrogen atom, sulfur atom, selenium atom and the like as a hetero atom and having an indenofluorene structure (the following formulae J to O).

5-membered ring heterocyclic groups containing a silicon atom, nitrogen atom, sulfur atom, selenium atom and the like as a hetero atom (the following formulae 94 to 98).

5-membered ring condensed heterocyclic groups containing a silicon atom, nitrogen atom, sulfur atom, selenium atom and the like as a hetero atom (the following formulae 99 to 110).

5-membered ring heterocyclic groups containing a silicon atom, nitrogen atom, sulfur atom, selenium atom and the like as a hetero atom, which are bonded at an α-position of its hetero atom to form a dimer or oligomer (the following formulae 111 to 112).

5-membered ring heterocyclic groups containing a silicon atom, nitrogen atom, sulfur atom, selenium atom and the like as a hetero atom, which are bonded at an α-position of its hetero atom to a phenyl group (the following formulae 113 to 119).

5-membered ring condensed heterocyclic groups containing an oxygen atom, nitrogen atom, sulfur atom and the like as a hetero atom, and carrying thereon a substituent such as a phenyl group, furyl group or thienyl group (the following formulae 120 to 125). 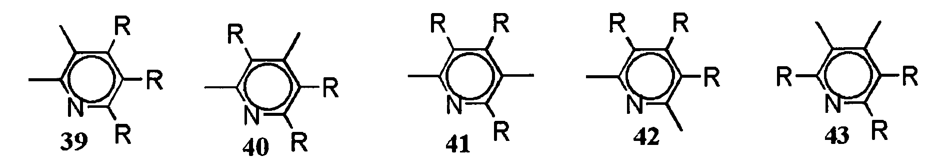 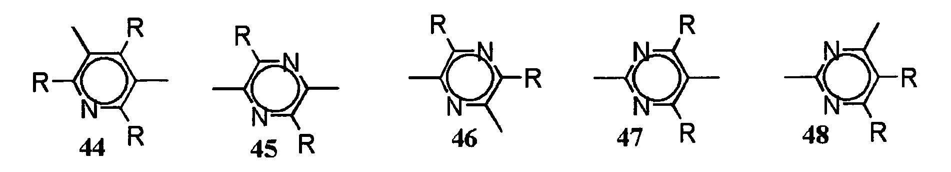 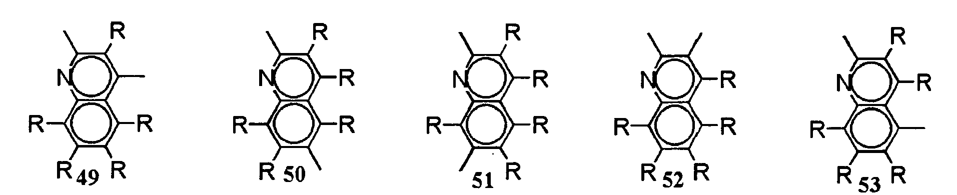 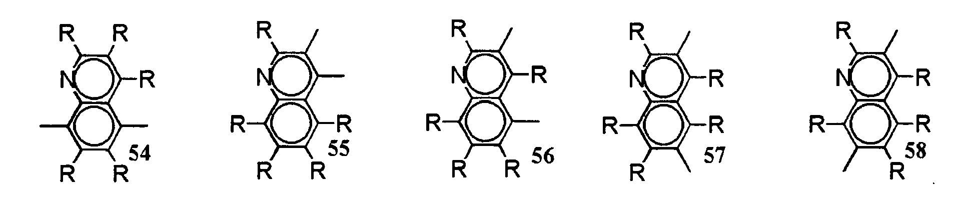 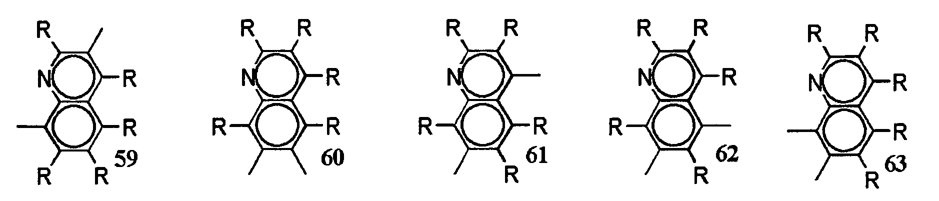 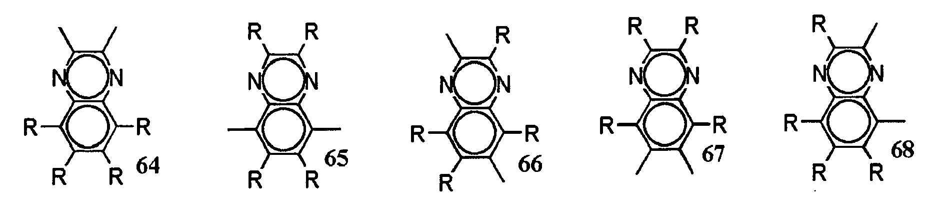 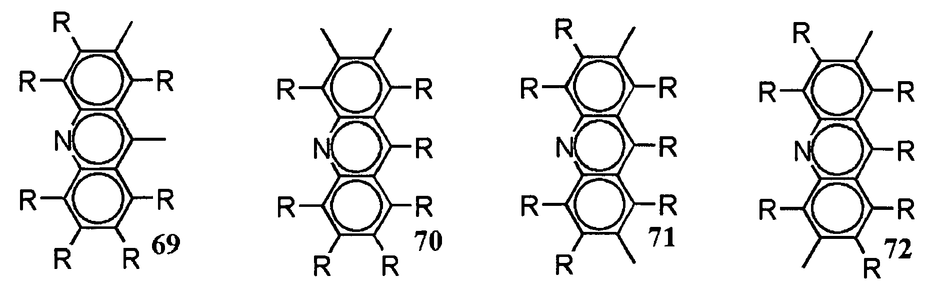 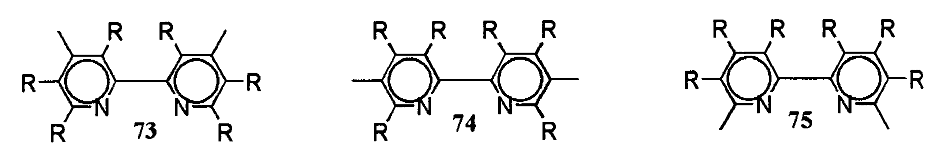 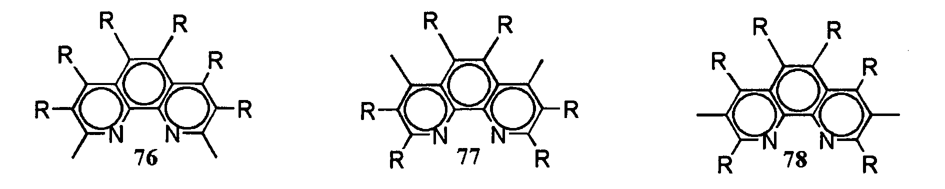 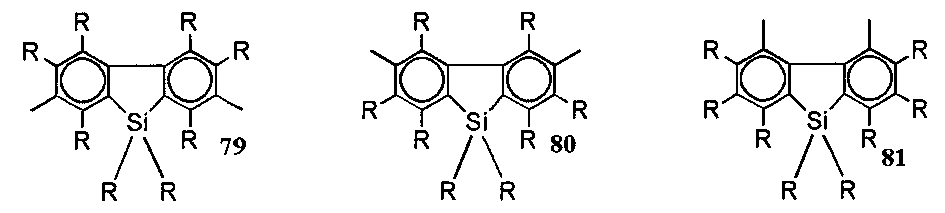 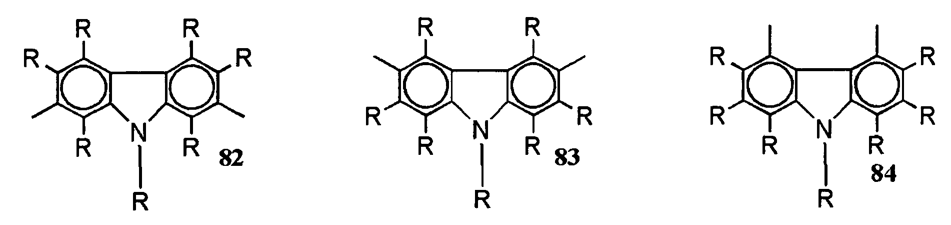 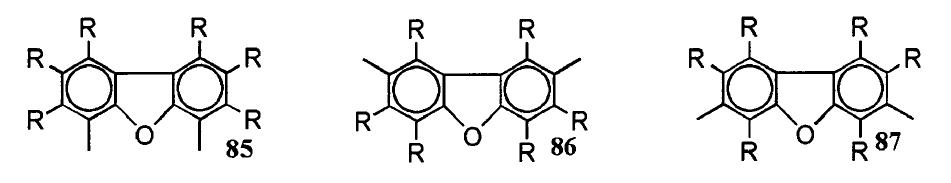 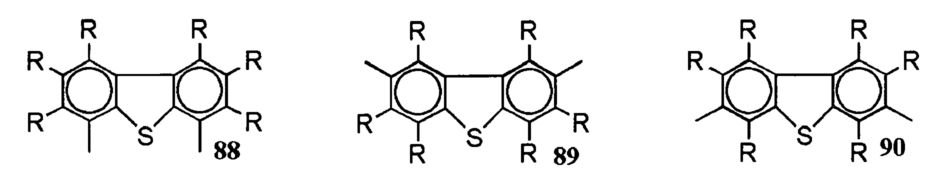 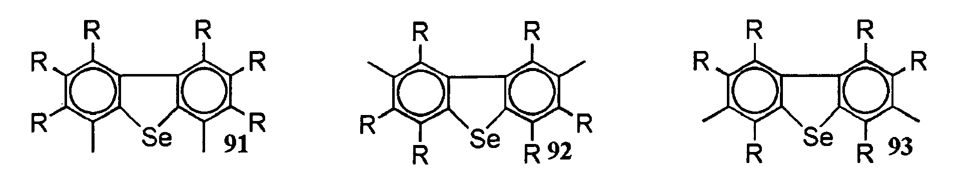 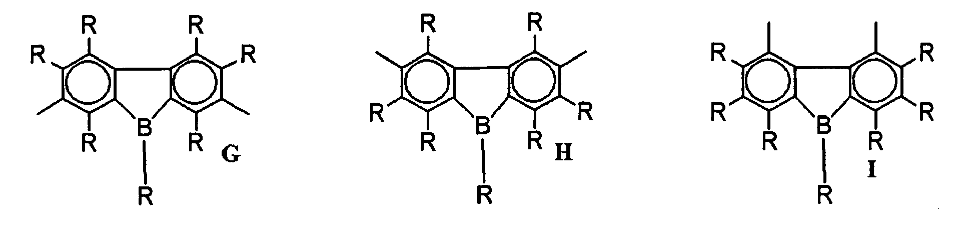 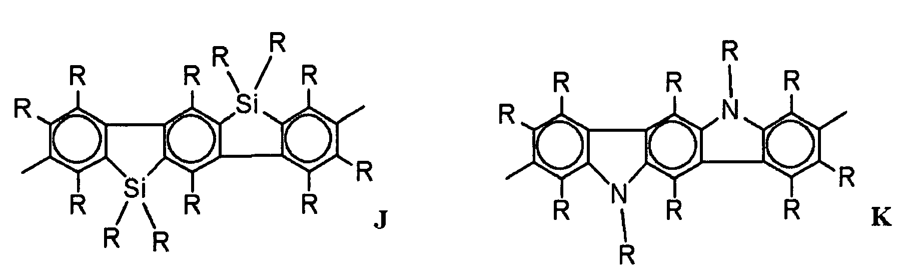 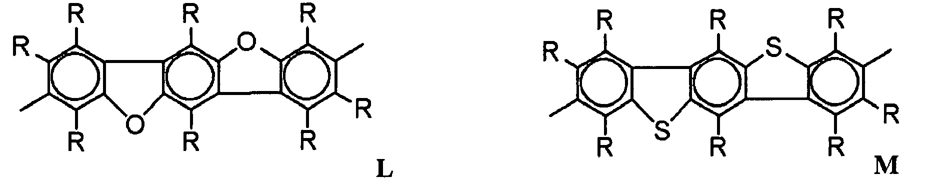 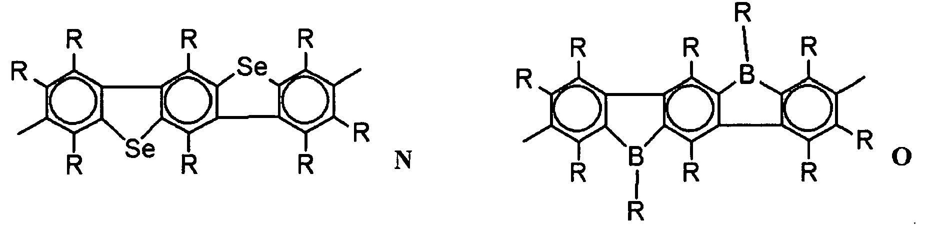 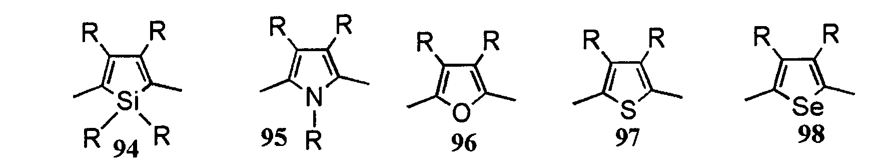 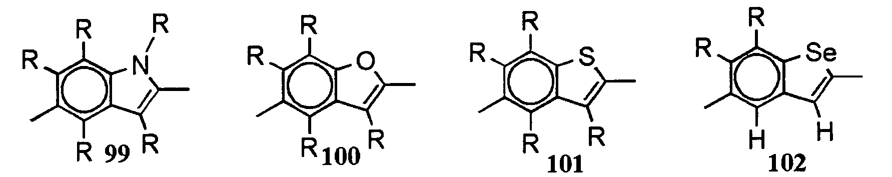 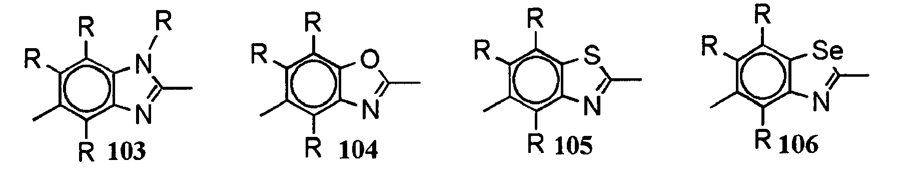 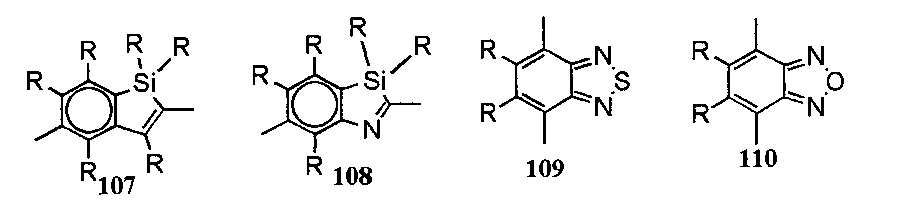 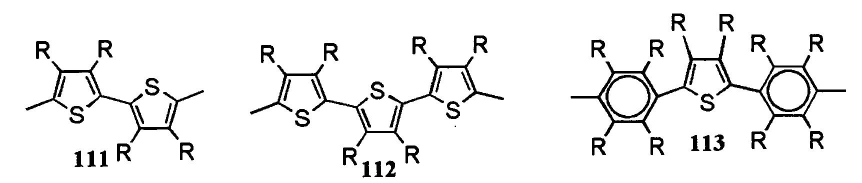 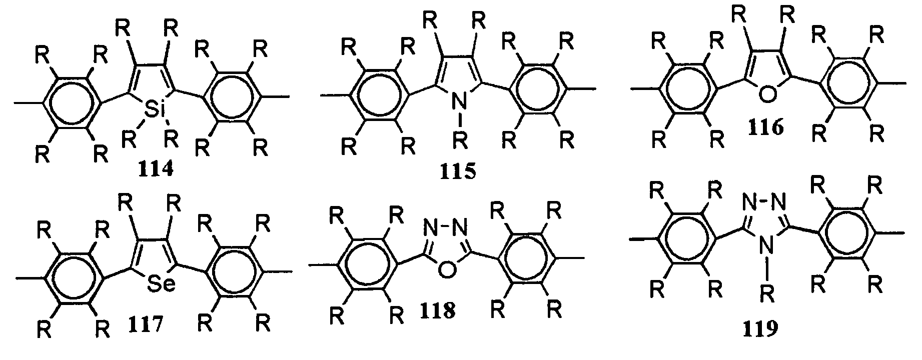 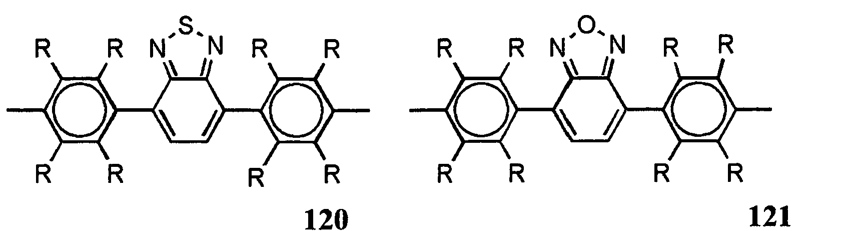 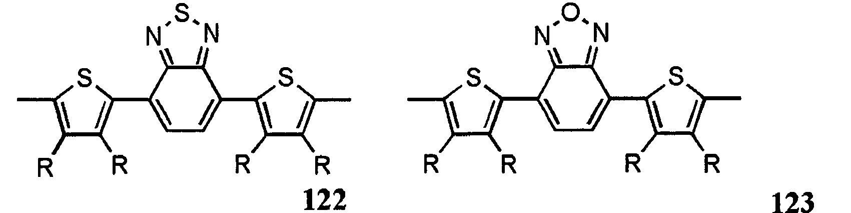 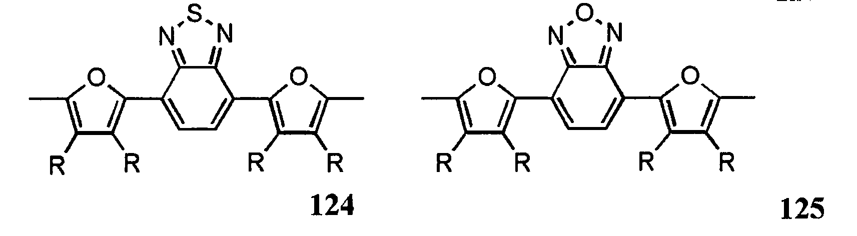 In formulae 1 to 125 and A to O, R represents a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, substituted silyl group, a silyloxy group, a substituted silyloxy group, a halogen atom, an acyl group, an acyloxy group, an imine residue, an amide group, an acid imide group, a monovalent heterocyclic group, a carboxyl group, a substituted carboxyl group or cyano group. A plurality of R may be the same or different.

In formula (4), (7) to (9), the di-valent group having a metal complex structure means a di-valent group remaining after removing two hydrogen atoms from an organic ligand of a metal complex having an organic ligand.

The number of carbon atoms of an organic ligand of the metal complex having an organic ligand is usually about 4 to 60.

Examples of the organic ligand include 8-quinolinol and derivatives thereof, benzoquinolinol and derivatives thereof, 2-phenyl-pyridine and derivatives thereof, 2-phenyl-benzothiazole and derivatives thereof, 2-phenyl-benzoxazole and derivatives thereof, porphyrin and derivatives thereof, and the like. Examples of the center metal of the metal complex having an organic ligand include aluminum, zinc, beryllium, iridium, platinum, gold, europium, terbium and the like. The metal complex having an organic ligand includes low molecular weight fluorescent materials, phosphorescent materials such as triplet light emitting complexes and the like; etc.

Examples of the di-valent group having a metal complex structure include groups of the following formulae 126 to 132.

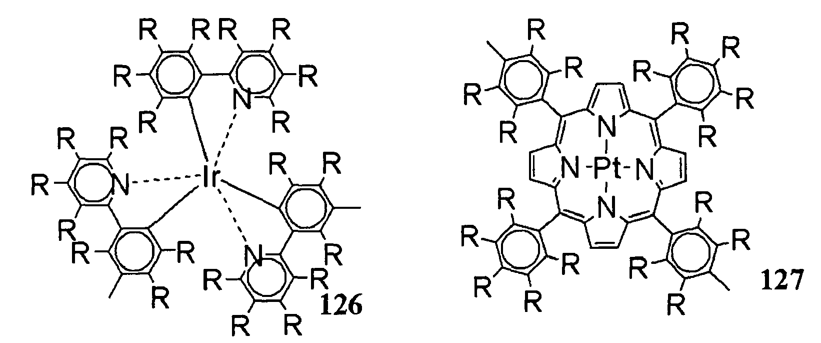

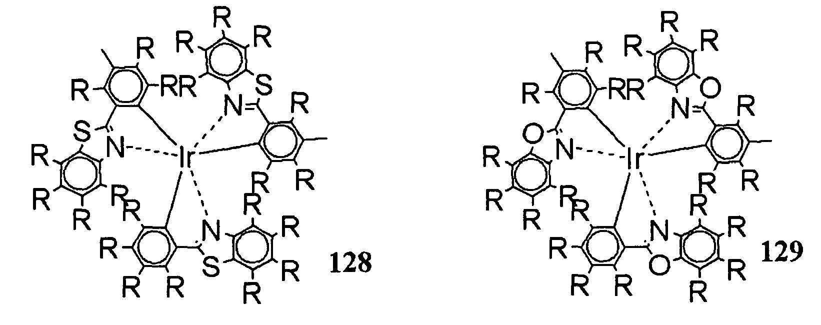

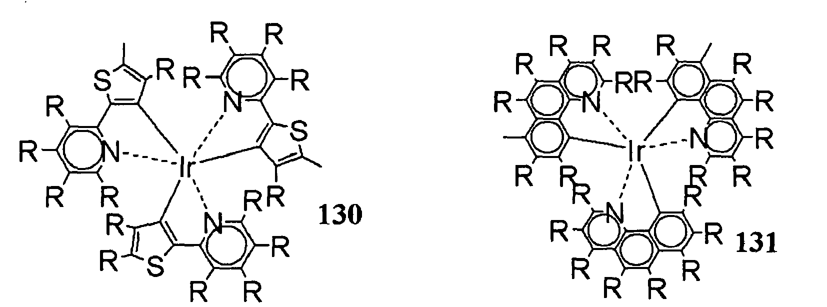

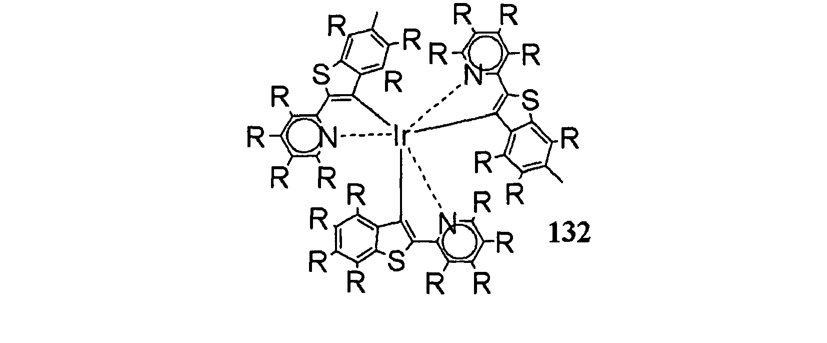

In formulae 126 to 132, R has the same meaning as described above. A plurality of R may be the same or different.

For enhancing solubility in a solvent, it is preferable that at least one of a plurality of R in one structural formula is a group other than a hydrogen atom, and it is preferable that the form of a repeating unit including substituents shows little symmetry. Further, it is preferable that at least one R in one structural formula is a group containing a cyclic or branched alkyl group. A plurality of R may be connected to form a ring.

When R is a substituent containing an alkyl group in the formula, this alkyl group may be a linear, branched or cyclic group, or a combination thereof, and for example, an isoamyl group, 2-ethylhexyl group, 3,7-dimethyloctyl group, cyclohexyl group, 4-C₁ to C₁₂ alkylcyclohexyl group and the like are exemplified.

For enhancing the solubility of the light emitting material in a solvent, it is preferable that a cyclic or branched alkyl chain is contained in one or more substituents on a repeating unit of formula (4) or formula (7). The ends of two alkyl chains may be connected to form a ring. Further, some carbon atoms of an alkyl chain may be substituted by a group containing a hetero atom. As this hetero atom, an oxygen atom, sulfur atom, nitrogen atom and the like are exemplified.

As the repeating unit of formula (7), the following units are preferable.

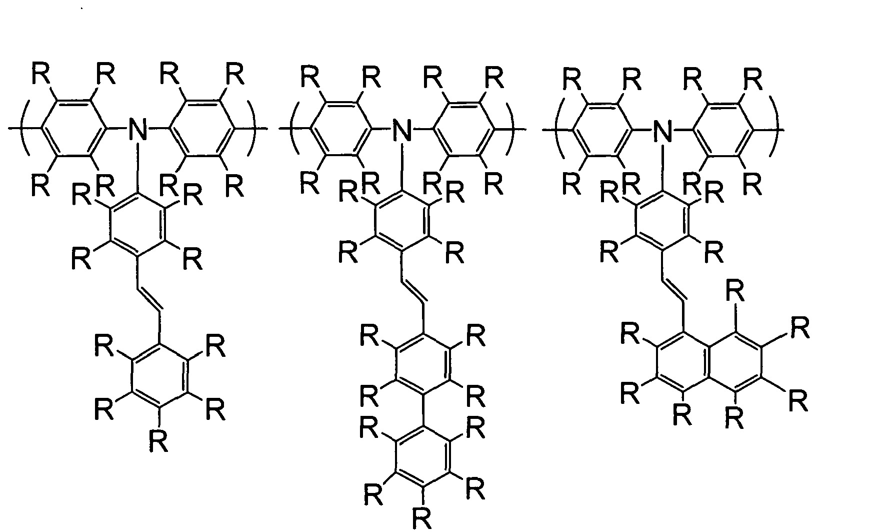

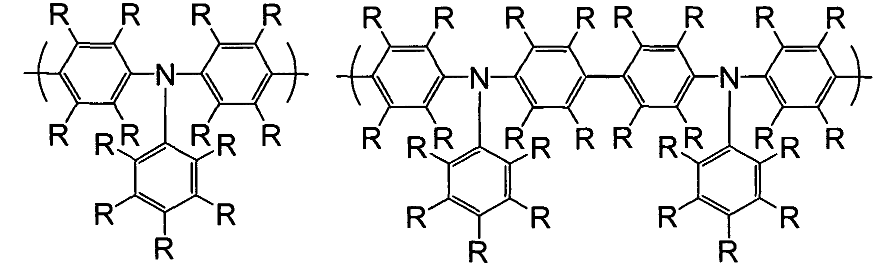

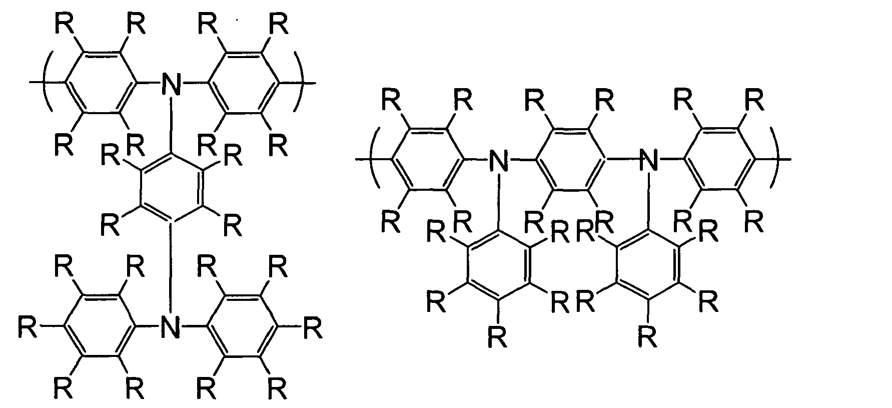

In the formulae, R has the same meaning as described above. A plurality of R may be the same or different..

The light emitting material may contain a repeating unit other than repeating units of formula (4) and formula (7). The sum of repeating units of formula (4) and formula (7) in light emitting material is usually 50 to 100 mol% with represent to all repeating units.

### Other layers

The organic electroluminescent device of the present invention may have a layer other than the first layer and the second layer. Such a layer includes a hole transporting layer which may be disposed between the first layer and the second layer and an electron transporting layer which may be disposed between the second layer and a cathode, and a hole transporting layer which may be disposed between the first layer and the second layer is preferable.

The hole transporting layer usually contains a hole transporting material and the electron transporting layer usually contains an electron transporting material. These hole transporting material and electron transporting material may be a polymer compound or a low molecular weight compound, and a polymer compound is preferable. As the hole transporting material and the electron transporting material, polyfluorene and derivatives thereof and copolymers containing a fluorenediyl group, polyarylene and derivatives thereof and copolymers containing an arylene group, polyarylenevinylene and derivatives thereof and copolymers containing an arylenevinylene group, aromatic amines and derivatives thereof and (co)polymers thereof, and the like, described in literatures listed in the above-described section of the light emitting material, are mentioned.

The hole transporting material as a polymer compound further includes, also polyvinylcarbazole and derivatives thereof, polysilane and derivatives thereof, polysiloxane derivatives having an aromatic amine on the side chain or main chain, polyaniline and derivatives thereof, polythiophene and derivatives thereof, polypyrrole and derivatives thereof, poly(2,5-thienylenevinylene) and derivatives thereof, and the like. The hole transporting material as a low molecular weight compound includes pyrazoline derivatives, arylamine derivatives, stilbene derivatives, triphenyldiamine derivatives and the like.

The hole transporting material as a polymer compound includes, more specifically, polymer compounds containing a repeating unit composed of an aromatic amine skeleton in the main chain. The content of the above-described repeating unit composed of an aromatic amine skeleton is preferably 30 to 100 mol% with respect to all repeating units in this polymer compound, and from the standpoint of further improving hole transportability, the content is more preferably 40 to 100 mol%, further preferably 50 to 85 mol%.

The hole transporting material as a polymer compound may contain other repeating units composed of an aromatic carbon ring and/or a conjugated compound residue having an aromatic hetero ring, in addition to the above-described repeating unit composed of an aromatic amine skeleton.

From the standpoint of hole injectability, the difference between the HOMO energy level of the above-described anode material and the HOMO energy level of the above-described hole transporting material is preferably 0.5 eV or less, more preferably 0.3 eV or less. In the present specification, "HOMO energy level of the anode material" means a value measured in the organic electroluminescent device of the present invention (obtained by subjecting the non-treated layer to a UV/ozone treatment).

As repeating unit composed of an aromatic amine skeleton, those of the following formula (5) are preferable: 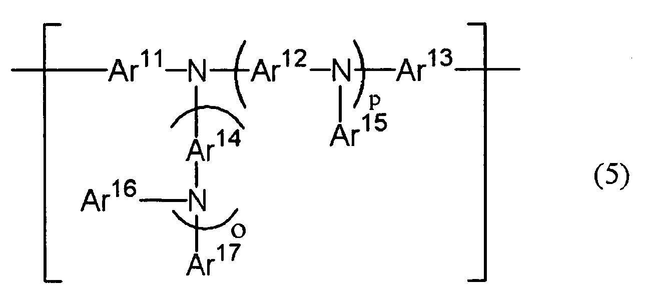 wherein Ar¹¹, Ar¹², Ar¹³ and Ar¹⁴ represent each independently an arylene group or di-valent heterocyclic group. Ar¹⁵, Ar¹⁶ and Ar¹⁷ represent each independently an aryl group or monovalent heterocyclic group. Ar¹⁶ and Ar¹⁷ may form a ring together with the nitrogen atom to which Ar¹⁶ and Ar¹⁷ are attached instead of representing the above-described groups. o and p represent each independently 0 or 1.

Of them, the organic electroluminescent device of the present invention having a hole transporting layer containing a hole transporting material containing a repeating unit of formula (5) between the first layer and the second layer in which the difference between the HOMO energy level of the anode material and the HOMO energy level of the hole transporting material is 0.5 eV or less is preferable, and one having a different of 0.3 eV or less is more preferable.

The arylene group and di-valent heterocyclic group in formula (5) are the same as those explained and exemplified in the sections of formulae (4), (7) to (9).

Examples of the repeating unit of formula (5) include those of the following formulae.

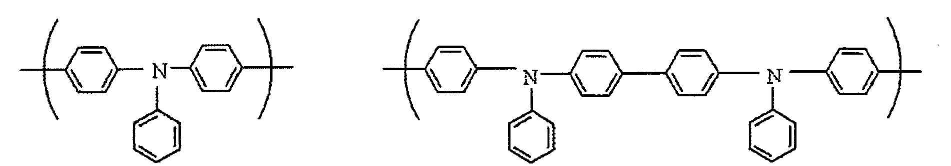

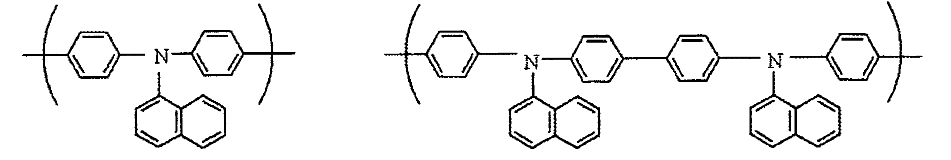

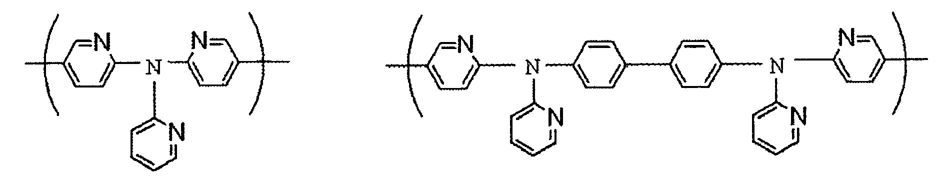

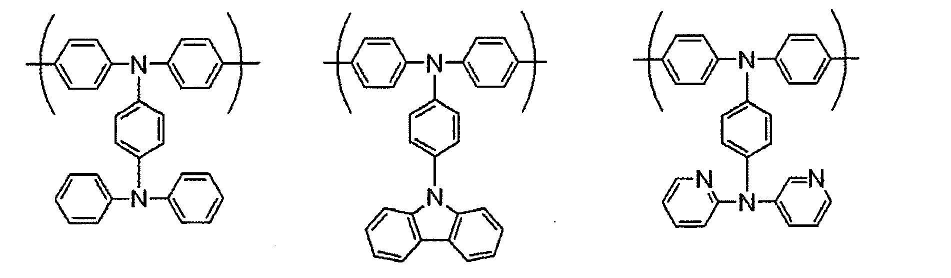

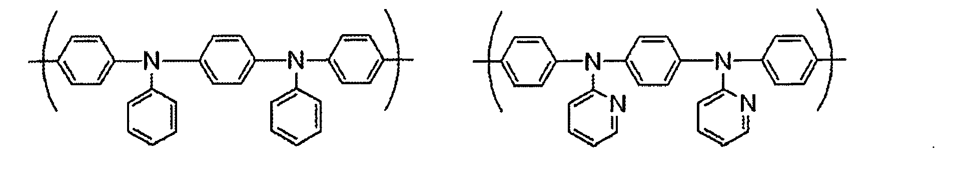

In the above-described formulae, hydrogen atoms on aromatic rings may be each independently substituted by an alkyl group having 1 to 20 carbon atoms, an alkoxy group having 1 to 20 carbon atoms, a phenylalkyl group having 7 to 26 carbon atoms,a phenylalkoxy group having 7 to 26 carbon atoms, a phenyl group, a phenoxy group, an alkyl group-substituted phenyl group having 7 to 26 carbon atoms, an alkoxy group-substituted phenyl group having 7 to 26 carbon atoms, an alkylcarbonyl group having 2 to 21 carbon atoms, a formyl group, an alkoxycarbonyl group having 2 to 21 carbon atoms, or a carboxyl group. When two substituents are present, these may be mutually connected to form a ring.

The phenylalkyl group has a number of carbon atoms of usually 7 to 26, preferably 11 to 21, more preferably 14 to 18, and examples thereof include a phenylmethyl group, a phenylethyl group, phenylpropyl group, a phenylbutyl group, a phenylpentyl group, a phenylhexyl group, a phenylheptyl group, a phenyloctyl group, a phenylnonyl group, a phenyldecyl group, a phenyldodecyl group and the like.

The phenylalkoxy group has a number of carbon atoms of usually 7 to 26, preferably 11 to 21, more preferably 14 to 18, and examples thereof include a phenylmethoxy group, a phenylethoxy group, a phenylpropyloxy group, a phenylbutoxy group, a phenylpentyloxy group, a phenylhexyloxy group, a phenylheptyloxy group, a phenyloctyloxy group, a phenylnonyloxy group, a phenyldecyloxy group, a phenyldodecyloxy group and the like.

The alkyl group-substituted phenyl group denotes a group in which at least one hydrogen atom on a phenyl group is substituted by an alkyl group having 1 to 20 carbon atoms, that is, a monoalkylphenyl group, a dialkylphenyl group, a trialkylphenyl group, a tetraalkylphenyl group and a pentaalkylphenyl group. The alkyl group-substituted phenyl group has a number of carbon atoms of usually 7 to 26, preferably 11 to 21, more preferably 14 to 18, and examples thereof include a mono, di, tri, tetra or penta-methylphenyl group; a mono, di, tri, tetra or penta-ethylphenyl group; a mono, di, tri, tetra or penta-propylphenyl group; a mono, di, tri, tetra or penta-isopropylphenyl group; a mono, di, tri, tetra or penta-butylphenyl group; a mono, di, tri, tetra or penta-isobutylphenyl group; a mono, di, tri, tetra or penta-s-butylphenyl group; a mono, di, tri, tetra or penta-t-butylphenyl group; a mono, di, tri, tetra or penta-pentylphenyl group; a mono, di, tri, tetra or penta-isoamylphenyl group; a mono, di, tri, tetra or penta-hexylphenyl group; a mono, di, tri, tetra or penta-heptylphenyl group; a mono, di, tri, tetra or penta-octylphenyl group; a mono, di, tri, tetra or penta-(2-ethylhexyl)phenyl group; a mono, di, tri, tetra or penta-nonylphenyl group; a mono, di, tri, tetra or penta-decylphenyl group; a mono, di, tri, tetra or penta-(3,7-dimethyloctyl)phenyl group; a mono, di, tri, tetra or penta-dodecylphenyl group, and the like.

The alkoxy group-substituted phenyl group denotes a group in which at least one hydrogen atom on a phenyl group is substituted by an alkoxy group having 1 to 20 carbon atoms, that is, a monoalkoxyphenyl group, a dialkoxyphenyl group, a trialkoxyphenyl group, a tetraalkoxyphenyl group and a pentaalkoxyphenyl group. The alkoxy group-substituted phenyl group has a number of carbon atoms of usually 7 to 26, preferably 11 to 21, more preferably 14 to 18, and examples thereof include a mono, di, tri, tetra or penta-methoxyphenyl group; a mono, di, tri, tetra or penta-ethoxyphenyl group; a mono, di, tri, tetra or penta-propyloxyphenyl group; a mono, di, tri, tetra or penta-isopropyloxyphenyl group; a mono, di, tri, tetra or penta-butoxyphenyl group; a mono, di, tri, tetra or penta-isobutoxyphenyl group; a mono, di, tri, tetra or penta-s-butoxyphenyl group; a mono, di, tri, tetra or penta-t-butoxyphenyl group; a mono, di, tri, tetra or penta-pentyloxyphenyl group; a mono, di, tri, tetra or penta-hexyloxyphenyl group; a mono, di, tri, tetra or penta-heptyloxyphenyl group; a mono, di, tri, tetra or penta-octyloxyphenyl group; a mono, di, tri, tetra or penta-(2-ethylhexyloxy)phenyl group; mono, di, tri, tetra or penta-nonyloxyphenyl group; a mono, di, tri, tetra or penta-decyloxyphenyl group; a mono, di, tri, tetra or penta-(3,7-dimethyloctyloxy)phenyl group; a mono, di, tri, tetra or penta-dodecyloxyphenyl group, and the like.

The alkylcarbonyl group has a number of carbon atoms of usually 2 to 21, preferably 5 to 15, more preferably 8 to 12, and examples thereof include an acetyl group, a propionyl group, a butyryl group, an isobutyryl group, a pentanoyl group,a hexanoyl group, a heptanoyl group, an octanoyl group, a 2-ethylhexanoyl group, a nonanoyl group, a decanoyl group, a 3,7-dimethyloctanoyl group, a dodecanoyl group and the like.

The alkoxycarbonyl group has a number of carbon atoms of usually 2 to 21, preferably 5 to 15, more preferably 8 to 12, and examples thereof include a methoxycarbonyl group, an ethoxycarbonyl group, a propyloxycarbonyl group, an isopropyloxycarbonyl group, a butoxycarbonyl group, an isobutoxycarbonyl group, a s-butoxycarbonyl group, a t-butoxycarbonyl group, a pentyloxycarbonyl group, a hexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, dodecyloxycarbonyl group and the like.

As the repeating unit of formula (5), those of the following formula (6) are preferable: 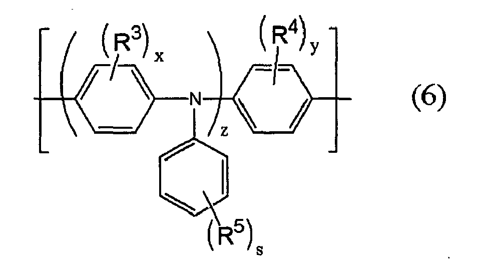 wherein R³, R⁴ and R⁵ represent each independently an alkyl group having 1 to 20 carbon atoms, an alkoxy group having 1 to 20 carbon atoms, a phenylalkyl group having 7 to 26 carbon atoms, a phenylalkoxy group having 7 to 26 carbon atoms, a phenyl group, a phenoxy group, an alkyl group-substituted phenyl group having 7 to 26 carbon atoms, an alkoxy group-substituted phenyl group having 7 to 26 carbon atoms, an alkylcarbonyl group having 2 to 21 carbon atoms, a formyl group, alkoxycarbonyl group having 2 to 21 carbon atoms or a carboxyl group. R³ and R⁴ may together form a ring instead of representing the above-described group. x and y represent each independently an integer of 0 to 4, z represents 1 or 2, and s represents an integer of 0 to 5. When two or more groups of at least one of R³, R⁴ and R⁵ are present, these two or more groups may be the same or different.

When R³ and R⁴ formula (6) together form a ring, examples of the ring include C₅ to C₁₄ heterocyclic rings which may have a substituent. Examples of the heterocyclic ring include a morpholine ring, a thiomorpholine ring, a pyrrole ring,a piperidine ring and a piperazine ring.

Examples of the repeating unit of formula (6) include repeating units of the following formulae (6-1) to (6-10).

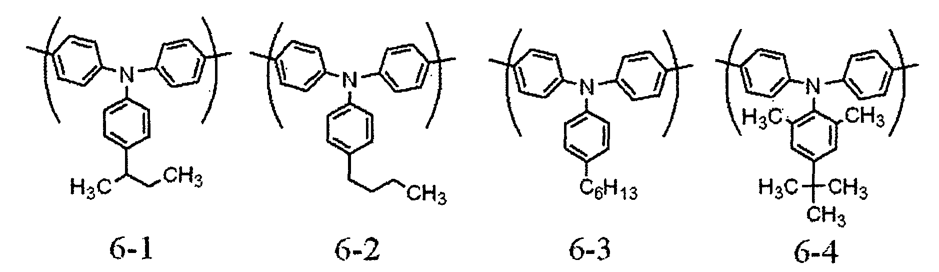

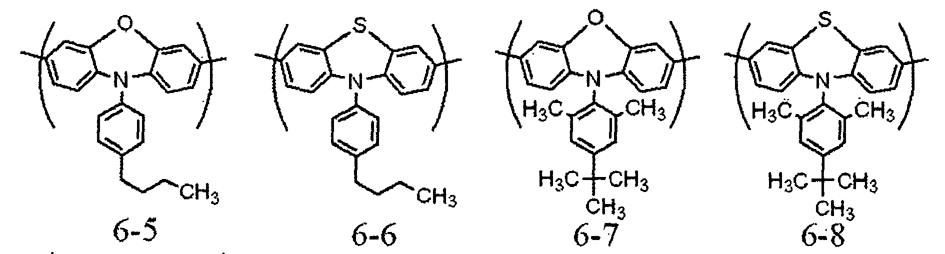

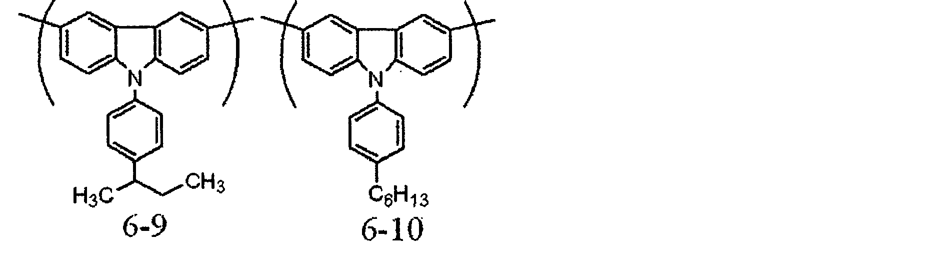

As the repeating unit of formula (6), those of the following formula (7) are preferable from the standpoint of solubility in a solvent, and the like: 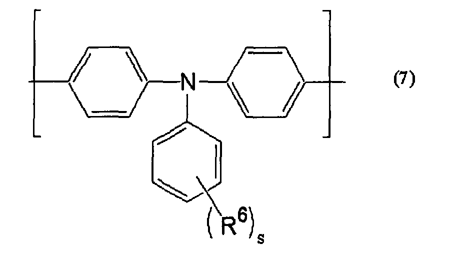 wherein R⁶ represents an alkyl group having 1 to 20 carbon atoms, and s represents an integer of 0 to 5. When there exists a plurality of R⁶, these may be the same or different.

As for the end part of the polymer compound, if a polymerization active group remains intact, there is a possibility of reduction in a light emitting property and life of a device produced using this polymer compound, thus, it is preferable that the end part is protected with a stable protective group. As the protective group, those having a conjugated bond continuing to a conjugated structure of the main chain are preferable, and there are exemplified structures in which an aryl group or a mono-valent heterocyclic group is connected to the main chain via a carbon-carbon bond. Examples of the protective group include substituents described as Chemical Formula 10 in JP-A No. 9-45478, and the like.

The polymer compound containing a repeating unit composed of an aromatic amine skeleton in the main chain preferably contains at least one of repeating units of the following formula (8) together with at least one of the repeating units composed of an aromatic amine skeleton, in the main chain, from the standpoint of device properties such as maximum light emission efficiency, device life and the like.

-[Ar⁸]- (8)

wherein Ar⁸ represents an arylene group.

The arylene group in formula (8) is the same as those explained and exemplified in the sections of formulae (4), (7) to (9).

Among repeating units of formula (8), repeating units of the following formula (9) are preferable from the standpoint of luminance half life. 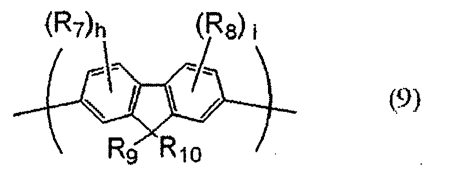 wherein R₇ and R₈ represent each independently a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a monovalent heterocyclic group, a heterocyclic thio group, an amino group, a silyl group, an acyl group, an acyloxy group, an imine residue, an amide group, an acid imide group, a carboxyl group, a cyano group or a nitro group, h and i represent each independently an integer of 0 to 3, and R₉ and R₁₀ represent each independently a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a monovalent heterocyclic group, a heterocyclic thio group, an amino group, a silyl group, an acyl group, an acyloxy group, an imine residue, an amide group, an acid imide group, a carboxyl group, a cyano group or a nitro group. When there exists a plurality of R₇ and R₈, these may be the same or different, respectively.

In formula (9), h and i represent preferably 0 or 1, particularly preferably 0, from the standpoint of easiness of synthesis of a raw material monomer.

In formula (9), R₉ and R₁₀ represent preferably an alkyl group or an aryl group, from the standpoint of easiness of synthesis of a raw material monomer.

Examples of the repeating unit of formula (9) include those of the following formulae (9-1) to (9-8).

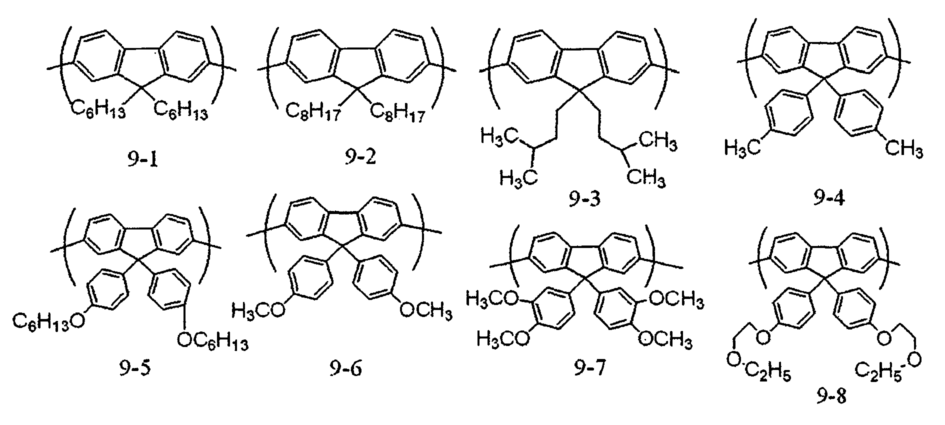

The polymer compound containing a repeating unit composed of an aromatic amine skeleton in the main chain has a polystyrene-equivalent number average molecular weight of preferably about 10³ to 10⁸, more preferably about 10⁴ to 10⁶.

In the present invention, the polystyrene-equivalent "number average molecular weight" and "weight average molecular weight" are measured using size exclusion chromatography (SEC) (manufactured by Shimadzu Corporation: LC-10 Avp). A sample to be measured is dissolved in tetrahydrofuran so as to give a concentration of about 0.5 wt%, and the solution was injected in an amount of 50 µL into SEC. Further, tetrahydrofuran is used as the mobile phase of SEC, and allowed to flow at a flow rate of 0.6 mL/min. As the column, two TSKgel Super HM-H (manufactured by Tosoh Corp.) and one TSKgel Super H2000 (manufactured by Tosoh Corp.) are connected serially. A differential refractometer (manufactured by Shimadzu Corp., trade name: RID-10A) is used as a detector.

Examples of the method of synthesizing the polymer compound containing a repeating unit composed of an aromatic amine skeleton in the main chain include a method of polymerization by the Suzuki coupling reaction from a monomer corresponding to the desired polymer compound, a method of polymerization by the Grignard reaction, a method of polymerization with a Ni(O) catalyst, a method of polymerization with an oxidizer such as FeCl₃ and the like, a method of electrochemical oxidation polymerization, a method by decomposition of an intermediate polymer compound having a suitable leaving group, and the like. Of them, a method of polymerization by the Suzuki coupling reaction, a method of polymerization by the Grignard reaction and a method of polymerization with a nickel (0) catalyst are preferable from the standpoint of easiness of control of the reaction

In the reaction, alkalis and suitable catalysts can be added appropriately, for promotion of the reaction. These alkalis and suitable catalysts may be selected depending on the kind of the reaction, and those showing sufficient dissolution in a solvent to be used in the reaction are preferable. Examples of the alkali include inorganic bases such as potassium carbonate, sodium carbonate and the like; organic bases such as triethylamine, tetraethylammonium hydroxide and the like; inorganic salts such as cesium fluoride and the like. Examples of the catalyst include tetrakis(triphenylphosphine)palladium, palladium acetates.

Since the purity of the polymer compound containing a repeating unit composed of an aromatic amine skeleton in the main chain exerts an influence on the light emitting property of a device, it is preferable to purify the monomer before polymerization by a method such as distillation, sublimation purification, recrystallization and the like, then, to polymerize the monomer, and it is preferable, after synthesis, to carry out a purification treatment such as reprecipitation purification, chromatographic fractionation and the like.

Examples of the solvent used in the reaction include saturated hydrocarbons such as pentane, hexane, heptane, octane, cyclohexane and the like; aromatic hydrocarbons such as benzene, toluene, ethylbenzene, xylene and the like; halogenated saturated hydrocarbons such as carbon tetrachloride, chloroform, dichloromethane, chlorobutane, bromobutane, chloropentane, bromopentane, chlorohexane, bromohexane, chlorocyclohexane, bromocyclohexane and the like; halogenated aromatic hydrocarbons such as chlorobenzene, dichlorobenzene, trichlorobenzene and the like; alcohols such as methanol, ethanol, propanol, isopropanol, butanol, t-butyl alcohol and the like; carboxylic acids such as formic acid, acetic acid, propionic acid and the like; ethers such as dimethyl ether, diethyl ether, methyl t-butyl ether, tetrahydrofuran, tetrahydropyran, dioxane and the like; inorganic acids such as hydrochloric acid, hydrobromic acid, hydrofluoric acid, sulfuric acid, nitric acid and the like; etc. These solvents may be used singly or in combination of two or more.

After the reaction, a coarse polymer compound can be obtained by a usual post treatment such as, for example, a process in which the reaction product is quenched with water, then, extracted with an organic solvent, and the organic solvent is distilled off, and the like. As described above, isolation and purification of the polymer compound can be carried out by methods such as preparative chromatography, recrystallization and the like.

As examples of the method of synthesizing the polymer compound, there are methods in which a compound of the following formula (10) is polymerized singly, or a compound of the following formula (10) and a compound of the following formula (11) are polymerized, by the above-described method.

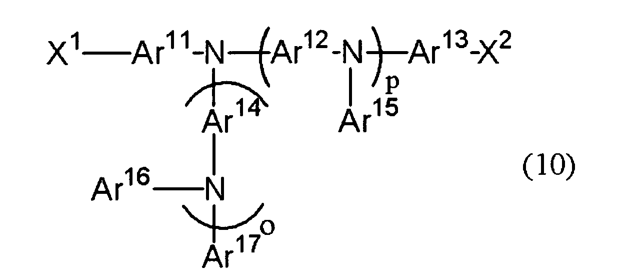

X³-Ar¹⁸-X⁴ (11)

wherein Ar¹¹ to Ar¹⁸ are as described above, and X¹ to X⁴ represent each independently a halogen atom, an alkylsulfo group, an arylsulfo group, an arylalkylsulfo group, a borate ester residue, a sulfoniummethyl group, a phosphoniummethyl group, a phosphonatemethyl group, a monohalogenated methyl group, a boric acid residue (-B(OH)₂), a formyl group or a vinyl group.

It is preferable that X¹ to X⁴ represent each independently a halogen atom, an alkylsulfo group, an arylsulfo group, an arylalkylsulfo group, a borate ester residue or a boric acid residue, from the standpoint of synthesis of a compound formula (10) or (11) and from the standpoint of easiness of reaction.

Examples of the alkylsulfo group include a methanesulfo group, an ethanesulfo group, a trifluoromethanesulfo group and the like. Examples of the arylsulfo group include a benzenesulfo group, a p-toluenesulfo group and the like. Examples of the arylalkylsulfo group include a benzylsulfo group and the like.

Examples of the borate ester residue include groups of the following formulae. 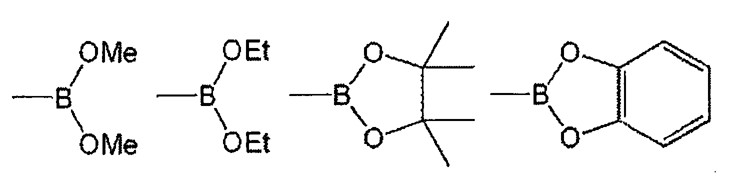 wherein Me represents a methyl group and Et represents an ethyl group.

Examples of the sulfoniummethyl group include groups of the following formulae.

-CH₂S⁺Me₂α⁻, -CH₂S⁺Ph²α⁻

wherein α represents a halogen atom, Me represents a methyl group, and Ph represents a phenyl group.

Examples of the phosphoniummethyl group include groups of the following formula.

-CH₂P⁺Ph³α⁻

wherein α represents a halogen atom and Ph represents a phenyl group.

Examples of the phosphonatemethyl group include groups of the following formula

-CH₂PO(OR¹¹)₂

wherein R¹¹ represents an alkyl group, aryl group or arylalkyl group.

Examples of the monohalogenated methyl group include a methyl fluoride group, a methyl chloride group, a methyl bromide group and a methyl iodide group

In laminating another layer, for example, a light emitting layer which shows light emission by recombination of a hole and an electron, onto a hole transporting layer containing a polymer compound containing a repeating unit composed of an aromatic amine skeleton in the main chain, it is preferable to insolubilize the hole transporting layer for preventing mixing of both the layers owing to a common solvent and elution of the hole transporting layer. As the treatment for insolubilization, exemplified are methods in which a soluble precursor or a polymer having a soluble substituent is used, the precursor is converted into a conjugated polymer by a thermal treatment, or the substituent is decomposed to lower solubility, thereby attaining insolubilization, methods in which a hole transportable polymer having a crosslinking group in the molecule is used, methods in which monomers or macromers generating a crosslinking reaction by heat, light, electron beam and the like are mixed, and other methods. Particularly, it is preferable to use a polymer compound having a crosslinking group in its molecule and containing a repeating unit composed of an aromatic amine skeleton in the main chain.

Examples of the polymer compound having a crosslinking group in its molecule and containing a repeating unit composed of an aromatic amine skeleton in the main chain include , the polymer compounds having a crosslinking group on its side chain and containing a repeating unit composed of an aromatic amine skeleton in the main chain. Examples of such a crosslinking group include a vinyl group, an acetylene group, a butenyl group, an acrylic group, an acrylate group, an acrylamide group, a methacryl group, a methacrylate group, a methacrylamide group, a vinyl ether group, a vinylamino group, a silanol group, groups having a small ring (for example, a cyclopropyl group, a cyclobutyl group, an epoxy group, an oxetane group, a diketene group, an episulfide group and the like), a lactone group, a lactam group, groups containing a siloxane derivative, and the like. In addition to these groups, combinations of groups capable of forming an ester bond or amide bond can also be used. For example, combinations of an ester group and amino group, an ester group and hydroxyl group, and the like are mentioned. Further, groups containing a benzocyclobutane structure described in Patent Specificaton WO 97/09394, and the like, are also exemplified. Of them, especially, an acrylate group and methacrylate are preferable.

Examples of the mono-functional monomer having an acrylate group or methacrylate group include 2-ethylhexylcarbitol acrylate, 2-hydroxyethyl acrylate and the like. Examples of the bi-functional monomer having an acrylate group or methacrylate group include 1,6-hexanediol diacrylate, 1,6-hexanediol dimethacrylate, ethylene glycol diacrylate, ethylene glycol dimethacrylate, neopentyl glycol diacrylate, neopentyl glycol dimethacrylate, triethylene glycol diacrylate, triethylene glycol dimethacrylate, 3-methylpentanediol diacrylate, 3-methylpentanediol dimethacrylate and the like. Examples of other polyfunctional monomers having an acrylate group or a methacrylate group include trimethylolpropane triacrylate, trimethylolpropane trimethacrylate, pentaerythritol triacrylate, pentaerythritol trimethacrylate, pentaerythritol tetraacrylate, pentaerythritol tetramethacrylate, dipentaerythritol pentaacrylate, dipentaerythritol pentamethacrylate, dipentaerythritol hexaacrylate, dipentaerythritol hexamethacrylate and the like.

In the polymer compound having a crosslinking group in its molecule and containing a repeating unit composed of an aromatic amine skeleton in the main chain, the content of the crosslinking group is usually 0.01 to 30 wt%, preferably 0.5 to 20 wt%, more preferably 1 to 10 wt%.

As the monomer and macromer generating a crosslinking reaction, exemplified are those having a polystyrene-equivalent weight average molecular weight of 2000 or less and having two or more of the crosslinking groups. Examples of the crosslinking reaction of the polymer having a crosslinking group and the monomer or macromer generating a crosslinking reaction include reactions occurring by heating, irradiation with light, electron beam and the like. The reaction may be carried out in the presence of a thermal polymerization initiator, a photopolymerization initiator, a thermal polymerization initiation aid, a photopolymerization initiation aid and the like.

In the case of insolubilization by heating, the heating temperature may be lower than the temperature at which the material is decomposed to lower its property, and for example, it is 50°C to 300°C, preferably 100°C to 250°C.

In the case of insolubilization by heating, as the thermal polymerization initiator which can be used together, use can be made of those generally known as a radical polymerization initiator, and for example, azo compounds such as 2,2'-azobisisobutyronitrile, 2,2'-azobis-(2,4-dimethylvaleronitrile), 2,2'-azobis(4-methoxy-2,4-dimethylvaleronitrile) and the like; organic peroxides such as benzoyl peroxide, lauroyl peroxide, t-butyl peroxy pivalate, 1,1'-bis(t-butyl peroxy) cyclohexane and the like; and hydrogen peroxide are mentioned.

In the case of use of a peroxide as the radical polymerization initiator, the peroxide may be used together with a reducing agent to give a redox type initiator. These thermal polymerization initiators can be used singly or in combination of two or more. The reaction temperature in the case of simultaneous use of a thermal polymerization initiator is, for example, 40°C to 250°C, preferably 50°C to 200°C. In photopolymerization using a photopolymerization initiator, irradiation with an ultraviolet ray may be performed at an irradiation intensity of 0.01 mW/cm² or more for 1 to 3600 seconds, preferably 30 to 600 seconds.

The photopolymerization initiator includes active radical generators generating an active radical by irradiation with light, acid generators generating an acid by irradiation with light, and the like. Examples of the active radical generator include acetophenone photopolymerization initiators, benzoin photopolymerization initiators, benzophenone photopolymerization initiators, thioxanthone photopolymerization initiators, triazine photopolymerization initiators, and the like. These photopolymerization initiators can be used singly or in combination of two or more.

As the electron transporting material used in an electron transporting layer, known materials can be used and exemplified are oxadiazole derivatives, anthraquinodimethane and its derivatives, benzoquinone and its derivatives, naphthoquinone and its derivatives, anthraquinone and its derivatives, tetracyanoanthraquinodimethane and its derivatives, fluorenone derivatives, diphenyldicyanoethylene and its derivatives, diphenoquinone derivatives, metal complexes of 8-hydroxyquinoline and its derivatives, polyquinoline and its derivatives, polyquinoxaline and its derivatives, polyfluorene and its derivatives, and the like. Those described in JP-A Nos. 63-70257, 63-175860, 2-135359, 2-135361, 2-209988, 3-37992 and 3-152184, and the like are exemplified as the electron transporting material.

Of them, oxadiazole derivatives, benzoquinone and its derivatives, anthraquinone and its derivatives, metal complexes of 8-hydroxyquinoline and its derivatives, polyquinoline and its derivatives, polyquinoxaline and its derivatives, polyfluorene and its derivatives are preferable, and 2-(4-biphenylyl)-5-(4-t-butylphenyl)-1,3,4-oxadiazole, benzoqinone, anthraquinone, tris(8-quinolinol)aluminum and polyquinoline are further preferable.

Examples of the laminated structure of the organic electroluminescent device of the present invention include the following structures. Further, an electron block layer, hole block layer, electron injection layer, hole injection layer and the like may be laminated.
anode/first layer/hole transporting layer/second layer/cathode
anode/first layer/hole transporting layer/second layer/electron transporting layer/cathode
(here, / represents lamination of layers or a layer and an electrode described on each side of this mark. Further, each layer may be disposed singly, or two or more layers may be disposed.)

In the organic electroluminescent device of the present invention, the thickness of the whole layer shows an optimum value varying depending on the material to be used, and may be advantageously regulated so as to give suitable values of driving voltage, light emission efficiency and device life, and is, for example, 30 nm to 1 µm, preferably 40 nm to 500 nm, further preferably 60 nm to 400 nm.

The thickness of each layer contained in the whole layer is appropriately selected so that light emission efficiency and driving voltage show desired values, and the thickness of the first layer is usually 0.1 to 10 nm, preferably 0.1 to 5 nm. The thickness of the hole transporting layer is usually 1 to 300 nm, preferably 5 to 50 nm. The thickness of the second layer is usually 5 to 300 nm, preferably 30 to 200 nm, further preferably 40 to 150 nm. The thickness of the electron transporting layer is usually 1 to 100 nm, preferably 1 to 40 nm.

In the present invention, methods of film formation from solution are used for production of the first layer, second layer, hole transporting layer, electron transporting layer and the like. For film formation from solution, for example, application methods such as a spin coat method, casting method, micro gravure coat method, gravure coat method, bar coat method, roll coat method, wire bar coat method, dip coat method, spray coat method, screen printing method, flexo printing method, offset printing method, inkjet printing method, nozzle coat method, capillary coat and the like can be used. Of them, printing methods such as a screen printing method, flexo printing method, offset printing method, inkjet printing method and the like are preferable since pattern formation and multicolor divisional painting are possible.

In the film formation method from solution, an ink is usually used. This ink contains materials constituting the layers, and a solvent. As this solvent, those capable of dissolving or uniformly dispersing components other than the solvent constituting the ink are preferable. Examples of the solvent include chlorine-based solvents such as chloroform, methylene chloride, 1,2-dichloroethane, 1,1,2-trichloroethane, chlorobenzene, o-dichlorobenzene and the like; ether solvents such as tetrahydrofuran, dioxane and the like; aromatic hydrocarbon solvents such as toluene, xylene and the like; aliphatic hydrocarbon solvents such as cyclohexane, methylcyclohexane, n-pentane, n-hexane, n-heptane, n-octane, n-nonane, n-decane and the like; ketone solvents such as acetone, methyl ethyl ketone, cyclohexanone and the like; ester solvents such as ethyl acetate, butyl acetate, ethylcellosolve acetate and the like; polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol and the like and derivatives thereof; alcohol solvents such as methanol, ethanol, propanol, isopropanol, cyclohexanol and the like; sulfoxide solvents such as dimethyl sulfoxide and the like; amide solvents such as N-methyl-2-pyrrolidone, N,N-dimethylformamide and the like. The solvents may be used singly or in combination of two or more.

The proportion of the solvent in the inks is 1 to 99.9 wt%, preferably 60 to 99.5 wt%, further preferably 80 to 99.0 wt% with respect to solutes (namely, total weight of a polymer compound containing a repeating unit composed of an aromatic amine skeleton in the main chain, and a luminescent material).

Though the viscosity of the ink varies depending on the kind of the printing method, the viscosity at 25°C is preferably in a range of 1 to 20 mPa•s for preventing clogging and flying curving in discharging when the ink passes through a discharge apparatus such as in an inkjet printing method and the like.

An insulation layer (usually, 10 nm or less) may be disposed next to the cathode. The material of the insulation layer includes metal fluorides and metal oxides, or organic insulating materials and the like, and preferable are fluorides and oxides of metals such as alkaline metals or alkaline earth metals. A vacuum vapor deposition method is exemplified for a film formation method of an inorganic compound to be used in the insulation layer.

The substrate which forms the organic electroluminescent device of the present invention may advantageously be one which does not change in forming an electrode and each layer of the device, and for example, substrates of glass, plastic, polymer film, silicon and the like are exemplified. In the case of an opaque substrate, it is preferable that an electrode nearer to the substrate and the opposite side electrode are transparent or semi-transparent. Here, "transparent" means that when a light having a wavelength of 750 to 400 nm passes through the electrode, the ratio (transmission factor) of the transmitted light intensity to the incident light intensity is 90 to 100%. "Semi-transparent" means that the transmission factor is 40% or more and less than 90%.

### Anode/cathode

Next, the anode and cathode contained in the organic electroluminescent device of the present invention will be explained. In the organic electroluminescent device of the present invention, it is advantageous that at least one of the anode and cathode is transparent or semi-transparent since, then, the generated light passes through this, thus, efficiency of taking out of the generated light is excellent. It is preferable that the anode is subjected to a UV/ozone treatment before the formation of the non-treated layer, for improving reactivity with the reactive group and X in formulae (1) to (3), (1'). In the organic electroluminescent device of the present invention, it is preferable that the anode side is transparent or semi-transparent.

As the anode, electric conductive glass (NESA and the like) composed of indium oxide, zinc oxide, tin oxide, and composite thereof: indium-tin-oxide (ITO), indium-zinc-oxide and the like, and gold, platinum, silver, copper and the like are used, and electric conductive inorganic oxides such as ITO, indium-zinc-oxide, tin oxide are preferable. As the anode, organic transparent electric conductive films made of polyaniline or its derivatives, polythiophene or its derivatives, and the like, may be used.

The thickness of the anode can be appropriately selected in view of light transmission and electric conductivity, and it is, for example, 10 nm to 10 µm, preferably 20 nm to 1 µm, and further preferably 50 nm to 500 nm.

As the method of fabricating the anode, a vacuum vapor deposition method, sputtering method, ion plating method, plating method and the like are mentioned.

The cathode is usually transparent or semi-transparent. As the material of the cathode, materials of small work function are preferable, and for example, alkali metals such as lithium, sodium, potassium, rubidium, cesium and the like, alkaline earth metals such as beryllium, magnesium, calcium, strontium, barium and the like, other metals such as aluminum, scandium, vanadium, zinc, yttrium, indium, cerium, samarium, europium, terbium, ytterbium and the like, alloys composed of two or more of them, or alloys composed of at least one of them and at least one of gold, silver, platinum, copper, manganese, titanium, cobalt, nickel, tungsten and tin, graphite or graphite intercalation compounds and the like are used. Examples of the alloy include a magnesium-silver alloy, magnesium-indium alloy, magnesium-aluminum alloy, indium-silver alloy, lithium-aluminum alloy, lithium-magnesium alloy, lithium-indium alloy, calcium-aluminum alloy and the like. The cathode may be disposed singly or two or more cathodes may be disposed. The cathode materials may be used singly or in combination of two or more.

The thickness of the cathode can be appropriately adjusted in view of electric conductivity and durability, and it is, for example, 10 nm to 10 µm, preferably 20 nm to 1 µm, and further preferably 50 nm to 500 nm.

For fabrication of the cathode, a vacuum vapor deposition method, sputtering method, lamination method of thermally press-binding a metal thin film, and the like are used. A layer made of an electric conductive polymer compound, or a layer made of a metal oxide, metal fluoride, organic insulation material and the like, may be provided.

After fabrication of the cathode, a protective layer for protecting the organic electroluminescent device may be installed. For use of the organic electroluminescent device stably for a long period of time, it is preferable to install a protective layer and/or protective cover, for protecting the device from outside.

As the protective layer, polymer compounds, metal oxides, metal nitrides, metal nitroxides, metal fluorides, metal borides and the like can be used. As the protective cover, a glass plate, and a plastic plate having a surface which has been subjected to low water permeation treatment, and the like can be used, and a method in which the cover is pasted to a device substrate with a thermosetting resin or photo-curing resin to attain sealing is suitably used. When a space is kept using a spacer, breakage of the device can be prevented easily. If an inert gas such as nitrogen, argon and the like is filled in this space, oxidation of the cathode can be prevented, further, by placing a drying agent such as barium oxide, calcium oxide and the like in this space, it becomes easy to suppress moisture adsorbed in a production process from lowering the performance of the device. It is preferable to adopt one strategy among these methods.

### <Application>

The organic electroluminescent device of the present invention can be used for a surface light source, display (e.g., segment display, dot matrix display), back light of liquid crystal display, and the like.

For obtaining light emission in the form of surface using the organic electroluminescent device of the present invention, a surface-formed anode and a surface-formed cathode may be disposed so as to overlap. For obtaining light emission in the form of pattern, there are a method in which a mask having a window in the form of pattern is placed on the surface of the above-mentioned surface light emitting device, a method in which a layer in non-light emitting parts is formed with extremely large thickness to give substantially no light emission, a method in which either anode or cathode, or both electrodes are formed in the form pattern. By forming a pattern by any of these methods, and placing several electrodes so that ON/OFF is independently possible, a display of segment type is obtained which can display digits, letters, simple marks and the like.

For providing a dot matrix device, it may be permissible that both an anode and a cathode are formed in the form of stripe, and placed so as to cross. By using a method in which several polymers showing different emission colors are painted separately or a method in which a color filter or a fluorescence conversion filter is used, partial color display and multi-color display are made possible. A dot matrix device may be based on passive driving, or active driving in combination with a thin film transistor using amorphous silicon or low temperature polysilicon. These displays can be used as a display of a computer, television, portable terminal, cellular telephone, car navigation, view finder of video camera, and the like.

The surface light emitting device is of self emitting and thin type, and can be suitably used as a surface light source for back light of a liquid crystal display, or as a surface light source for illumination. If a flexible substrate is used, it can also be used as a curved light source or display.

### EXAMPLES

Examples and comparative examples will be shown below for illustrating the present invention further in detail, but the present invention is not limited to these examples.

### <Synthesis Example 1> (Synthesis of polymer compound A

### - hole transportable polymer compound -)

Into a flask connected to a dimroth was added 5.25 g (9.9 mmol) of a compound A of the following formula: 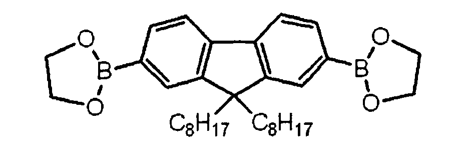 4.55 g (9.9 mmol) of a compound of the following formula: 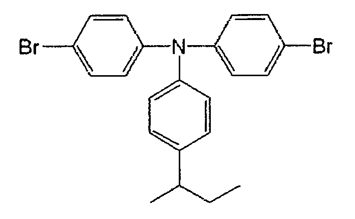 0.91 g of methyltrioctylammonium chloride (trade name: Aliquat (registered trademark) 336, manufactured by Aldrich) and 69 ml of toluene, to obtain a monomer solution. Under a nitrogen atmosphere, the monomer solution was heated, and 2 mg of palladium acetate and 15 mg of tris(2-methylphenyl)phosphine were added at 80°C. Into the resultant solution, 9.8 g of 17.5 wt% sodium carbonate aqueous solution was poured, then, the mixture was stirred at 110°C for 19 hours. To this was added 121 mg of phenylboric acid dissolved in 1.6 ml of toluene, and the mixture was stirred at 105°C for 1 hour.

The organic phase and aqueous phase of the resultant reaction liquid were separated, then, 300 ml of toluene was added to the organic phase.

The resultant organic phase was washed with 40 ml of 3 wt% acetic acid aqueous solution (twice) and 100 ml of ion exchanged water (once), in this order. To the washed organic phase was added 0.44 g of sodium N,N-diethyldithiocarbamate tri-hydrate and 12 ml of toluene, and the mixture was stirred at 65°C for 4 hours.

The resultant toluene solution of the reaction product was allowed to pass through a silica gel/alumina column through which toluene had been previously passed, and this solution was dropped into 1400 ml of methanol, to generate a precipitate. This precipitate was filtrated, then, dried to obtain a solid. This solid was dissolved in 400 ml of toluene, and the resultant solution was dropped into 1400 ml of methanol, to cause precipitation of a polymer, and the precipitate was filtrated, then, dried, to obtain 6.33 g of a polymer compound A. The polymer compound A had a polystyrene-equivalent number average molecular weight Mn of 8.8×10⁴ and a weight average molecular weight Mw of 3.2×10⁵ The polymer compound A is guessed to contain repeating units of the following formulae at 1:1 (molar ratio), based on the charged raw materials. 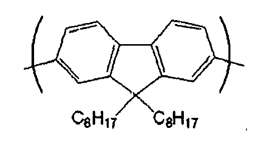 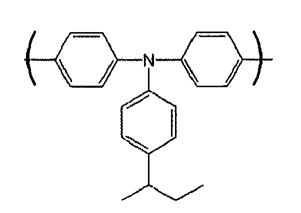 The HOMO energy level of the polymer compound A was 5.4 eV.

### <Example 1>

A glass substrate carrying thereon an ITO film having a thickness of 150 nm provided by a sputtering method was subjected to a UV/ozone treatment for 20 minutes using a UV/ozone apparatus (manufactured by Technovision Inc.). 3-aminopropyltrimethoxysilane (manufactured by Azmax Co.) was dissolved with a concentration of 0.07 wt% in a methanol:water = 95:5 mixed solvent (weight ratio) to prepare a solution. pH of this solution was confirmed by a pH meter, to find a value of 10.41 (weak alkaline). On this substrate, this solution was spin-coated at a rate of 2000 rpm to form a film (first layer). The average thickness of this first layer was measured to find a value of 10 nm or less. After film formation, the substrate was heated on a hot plate at 110°C for 30 minutes under atmospheric air.

After cooling down to room temperature, a UV/ozone treatment was carried out for 20 minutes using a UV/ozone apparatus (UV radiation dose: 10 J/cm²). A xylene solution of the polymer compound A so prepared as to have a solid concentration of about 0.5 wt% was spin-coated on the substrate to form a film with a thickness of about 10 nm or less, then, heated at 200°C for 15 minutes under a nitrogen atmosphere.

Next, on the film made of the polymer compound A, a light emitting layer (second layer) was formed. As the light emitting layer, Lumation BP361 (manufactured by Sumation) (hereinafter, referred to as "Lumation BP361") was used. A xylene solution of Lumation BP361 so prepared as to have a solid concentration of about 1.2 wt% was spin-coated to form a film with a thickness of 80 nm on the film made of the polymer compound A. Thereafter, the film was dried at 130°C for 20 minutes under a nitrogen atmosphere, then, as a cathode, barium was vapor-deposited with a thickness of about 5 nm, then, aluminum was vapor-deposited with a thickness of about 100 nm, to fabricate an organic electroluminescent device. After the degree of vacuum reached 1×10⁻⁴Pa or less, metal vapor deposition was initiated. The HOMO energy level of the material of the anode of the resultant device was 5.1 eV.

Voltage was applied on the resultant device, to observe blue light emission having a peak wavelength of 470 nm ascribable to Lumation BP361. The light emission initiation voltage to show 1 cd/m² was 2.9 V, and the maximum light emission efficiency was 7.5 cd/A This device was driven at a constant current density of 35.25 mA/cm², to find an initial luminance of 2430 cd/m², and the time until the luminance was reduced by half was about 52 hours.

### <Comparative Example 1>

Film formation of 3-aminopropyltrimethoxysilane was carried out in the same manner as in Example 1, then, the resultant substrate was heated on a hot plate at 110°C for 30 minutes under atmospheric air. Then, after cooling down to room temperature, an organic electroluminescent device was fabricated in the same manner as in Example 1 excepting that a plasma treatment was carried out for 2 minutes using an oxygen plasma apparatus under conditions of a plasma output of 100 W, a pressure of 0.5 Pa and an oxygen flow rate of 40 sccm, instead of performing a UV/ozone treatment for 20 minutes using a UV/ozone apparatus.

Voltage was applied on the resultant device, to observe blue light emission having a peak wavelength of 470 nm ascribable to Lumation BP361. The light emission initiation voltage to show 1 cd/m² was 9.1 V, and the maximum light emission efficiency was 0.07 cd/A This device was driven at a constant current density of 35.25 mA/cm², to find an initial luminance of 11 cd/m², and the time until the luminance was reduced by half was about 1 hour.

### <Comparative Example 2>

On a glass substrate carrying thereon an ITO film having a thickness of 150 nm provided by a sputtering method, a suspension of poly(3,4)ethylenedioxythiophene/polystyrenesulfonic acid (manufactured by Bayer, Baytron P CH8000)(hereinafter, referred to as "Baytron P CH8000") was spin-coated to form a film with a thickness of 80 nm, and dried on a hot plate at 200°C for 10 minute (first layer). pH of Baytron P CH8000 was confirmed by a pH meter, to find a value of 2.09 (strong acidic). After cooling down to room temperature, a xylene solution of the polymer compound A so prepared as to have a solid concentration of about 0.5 wt% was spin-coated on the substrate to form a film with a thickness of about 10 nm. Then, the film was heated at 200°C for 15 minutes under a nitrogen atmosphere.

Next, a light emitting layer (second layer) was formed in the same manner as in Example 1, to fabricate an organic electroluminescent device.

Voltage was applied on the resultant device, to observe blue light emission having a peak wavelength of 470 nm ascribable to Lumation BP361. The light emission initiation voltage to show 1 cd/m² was 3.1 V, and the maximum light emission efficiency was 7.9 cd/A This device was driven at a constant current density of 33.5 mA/cm², to find an initial luminance of 2400 cd/m², and the time until the luminance was reduced by half was about 41 hours.

### <Comparative Example 3>

A glass substrate carrying thereon an ITO film having a thickness of 150 nm provided by a sputtering method was subjected to a UV/ozone treatment for 20 minutes using a UV/ozone apparatus (manufactured by Technovision Inc.). 3-aminopropyltrimethoxysilane (manufactured by Azmax Co.) was dissolved with a concentration of 1.0 wt% in a methanol:water = 95:5 mixed solvent (weight ratio) to prepare a solution, and this solution was spin-coated on this substrate at a rate of 1000 rpm to form a film (first layer). The average thickness of the first layer was measured to find a value of 35 nm. After film formation, the substrate was heated on a hot plate at 110°C for 30 minutes under atmospheric air.

After cooling down to room temperature, a UV/ozone treatment was carried out for 20 minutes using a UV/ozone apparatus (UV radiation dose: 10 J/cm²). A xylene solution of the polymer compound A so prepared as to have a solid concentration of about 0.5 wt% was spin-coated on the substrate to form a film with a thickness of about 10 nm or less, then, heated at 200°C for 15 minutes under a nitrogen atmosphere.

Next, a UV/ozone treatment was carried out and a light emitting layer (second layer) was formed in the same manner as in Example 1, to fabricate an organic electroluminescent device.

Voltage was applied on the resultant device, to observe blue light emission having a peak wavelength of 470 nm ascribable to Lumation BP361. However, the light emission initiation voltage to show 1 cd/m² was 8.6 V, and the maximum light emission efficiency was 0.43 cd/A. This device was driven at a constant current density of 250 mA/cm², to find an initial luminance of 1820 cd/m², and the time until the luminance was reduced by half was about 2 hours.

### <Comparative Example 4>

A glass substrate carrying thereon an ITO film having a thickness of 150 nm provided by a sputtering method was subjected to a UV/ozone treatment for 20 minutes using a UV/ozone apparatus (manufactured by Technovision Inc.). 3-aminopropyltrimethoxysilane (manufactured by Azmax Co.) was dissolved with a concentration of 5.0 wt% in a methanol:water = 95:5 mixed solvent (weight ratio) to prepare a solution, and this solution was spin-coated on this substrate at a rate of 1000 rpm to form a film (first layer). The average thickness of the first layer was measured to find a value of 130 nm. After film formation, the substrate was heated on a hot plate at 110°C for 30 minutes under atmospheric air.

After cooling down to room temperature, a UV/ozone treatment was carried out for 20 minutes using a UV/ozone apparatus (UV radiation dose: 10 J/cm²). A xylene solution of the polymer compound A so prepared as to have a solid concentration of about 0.5 wt% was spin-coated on the substrate to form a film with a thickness of about 10 nm or less, then, heated at 200°C for 15 minutes under a nitrogen atmosphere.

Next, a light emitting layer (second layer) was formed in the same manner as in Example 1, to fabricate an organic electroluminescent device.

Voltage was applied on the resultant device, however, this device did not reach 1 cd/m² even if a voltage of 15 V was applied.

### <Evaluation>

In Example 1, since the solution used for fabrication of the first layer of the organic electroluminescent device is a weakly acidic system and the first layer can be formed by a simple method such as a UV/ozone treatment, workability is remarkably excellent. The resultant device has a life (luminance half life) of about 52 hours, thus, the device is recognized to have long life.

In Comparative Example 1, a complicated vacuum process such as an oxygen plasma treatment is necessary in formation of the first layer of the organic electroluminescent device, that is, workability is poor. The resultant device has a life (luminance half life) of about 1 hour, thus, the device shows poor practicality.

In Comparative Example 2, since the solution used for fabrication of the first layer of the organic electroluminescent device is a strong acidic system, workability is poor. The resultant device has a life (luminance half life) of about 41 hours, which is inferior by about 20% as compared with the life (luminance half life) of the organic electroluminescent device in Example 1.

In Comparative Example 3, the average thickness of the first layer is 35 nm, which does not satisfy the desired average thickness. As a result, for the resultant device, the light emission initiation voltage to show 1 cd/m² is higher by as much as 5.7 V, the maximum light emission efficiency is 1/10 or less, and the life (luminance half life) is as extremely short as about 2 hours.

In Comparative Example 4, the average thickness of the first layer is 130 nm, which does not satisfy the desired average thickness. As a result, for the resultant device, light emission is scarcely observed even if a voltage of 15 V is applied.

### Industrial Applicability

The organic electroluminescent device of the present invention is excellent in workability (for example, workability in a production process such as coating, film formation and the like, and simplicity of treatment), thus, the production of the device is easy. The organic electroluminescent device of the present invention is useful for production of a flat or curved surface light source used for illumination and the like; displays such as a segment display, dot matrix display and the like; a back light of a liquid crystal display and the like, since the device usually has a long life.

## Claims

1. An organic electroluminescent device comprising an anode, a first layer disposed on the anode, a second layer containing a light emitting material, and a cathode,
wherein the first layer is a layer formed on the anode by forming a non-treated layer containing a compound having a group reactive to a group present on the surface of the anode and subjecting the non-treated layer to a UV/ozone treatment, and the first layer has an average thickness of 10 nm or less.

2. The organic electroluminescent device according to Claim 1, wherein the compound having a group reactive to a group present on the surface of the anode comprises at least one compound selected from the group consisting of compounds of the following formula (1) and partially hydrolyzed condensates thereof, compounds having a monovalent group of the following formula (2) and partially hydrolyzed condensates thereof, and compounds of the following formula (3) and partially hydrolyzed condensates thereof:
M¹(X)ᵥ₁(R^{a})ᵤ₋ᵥ₁ (1)
-M²(X)ᵥ₂(R^{a})ᵤ₋ᵥ₂₋₁ (2)
-[Si(X)_{w}(R^{a})_{2-w}-O]ₙ- (3)
wherein M¹ represents a metal atom belonging to Group IV, Group V, Group VI, Group XIII or Group XV of the periodic table or a carbon atom, a germanium atom, a tin atom or a lead atom; M² represents a metal atom belonging to Group IV, Group V, Group VI, Group XIII, Group XIV or Group XV of the periodic table; X represents a group reactive to a group present on the surface of the anode; R^{a} represents an alkyl group, an aryl group, an arylalkyl group, an arylalkenyl group or an arylalkynyl group; the group represented by R^{a} may have a substituent; v1 represents an integer of 1 or more and u or less; v2 represents an integer of 1 or more and u-1 or less; w is 1 or 2; u represents the valence of M¹ or M²; when there exists a plurality of X, these may be the same or different; when there exists a plurality of R^{a}, these may be the same or different;n represents the degree of polymerization.

3. The organic electroluminescent device according to Claim 2, wherein the compound having a group reactive to a group present on the surface of the anode comprises at least one compound selected from the group consisting of compounds having a monovalent group of formula (2) in which M² is a silicon atom and partially hydrolyzed condensates thereof, and compounds of formula (3) and partially hydrolyzed condensates thereof.

4. The organic electroluminescent device according to Claim 2, wherein the compound having a group reactive to a group present on the surface of the anode comprises at least one compound selected from the group consisting of compounds of formula (1) in which M¹ is a titanium atom and partially hydrolyzed condensates thereof, and compounds having a monovalent group of formula (2) in which M² is a titanium atom and partially hydrolyzed condensates thereof.

5. The organic electroluminescent device according to Claim 1, wherein the compound having a group reactive to a group present on the surface of the anode comprises at least one compound selected from the group consisting of compounds of the following formula (1') and partially hydrolyzed condensates thereof:
Si(X)ᵥ₁(R^{a})ᵤ₋ᵥ₁ (1')
wherein X, R^{a}, v1 and u have the same meanings as defined above.).

6. The organic electroluminescent device according to any one of Claims 1 to 5, wherein the light emitting material contains a polymer compound containing a repeating unit of formula (4):
-[Ar⁵-(L¹)ₖ]- (4)
wherein Ar⁵ represents an arylene group, a divalent heterocyclic group or a divalent group having a metal complex structure; L¹ represents -CR¹⁵=CR¹⁶- or -C≡C-; and R¹⁵ and R¹⁶ represent each independently a hydrogen atom, an alkyl group, an aryl group, a monovalent heterocyclic group or a cyano group; k represents an integer of 0 to 2; when there exists a plurality of L¹, these may be the same or different.

7. The organic electroluminescent device according to any one of Claims 1 to 6 which has, between the first layer and the second layer, a hole transporting layer containing a hole transporting material containing a repeating unit of formula (5): 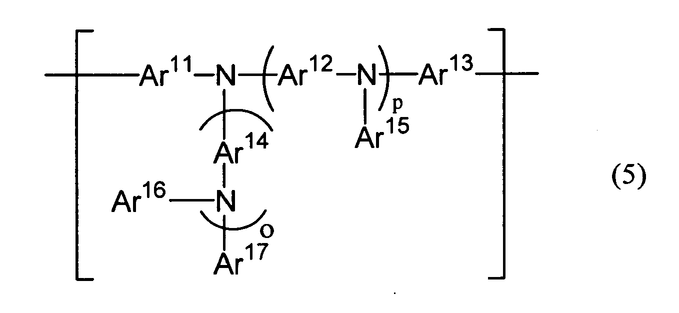 wherein Ar¹¹, Ar¹², Ar¹³ and Ar¹⁴ represent each independently an arylene group or a divalent heterocyclic group; Ar¹⁵, Ar¹⁶ and Ar¹⁷ represent each independently an aryl group or a monovalent heterocyclic group; Ar¹⁶ and Ar¹⁷ may form a ring together with the nitrogen atom to which Ar¹⁶ and Ar¹⁷ are attached instead of representing the above-described groups; o and p represent each independently 0 or 1.
and the difference between the HOMO energy level of the material of the anode and the HOMO energy level of the hole transporting material is 0.5 eV or less.

8. The organic electroluminescent device according to any one of Claims 1 to 7, wherein the UV radiation dose used in the UV/ozone treatment is 1 J/cm² or more.

9. The organic electroluminescent device according to any one of Claims 1 to 8, wherein the anode is one having been subjected to a UV/ozone treatment before the formation of the non-treated layer.

10. A surface light source comprising the organic electroluminescent device as described in any one of Claims 1 to 9.

11. A display comprising the organic electroluminescent device as described in any one of Claims 1 to 9.

12. A method of producing an organic electroluminescent device comprising an anode, a first layer disposed on the anode, a second layer containing a light emitting material, and a cathode,
the method comprising a step of forming a non-treated layer containing a compound having a group reactive to a group present on the surface of the anode and a step of subjecting the non-treated layer to a UV/ozone treatment to form the first layer on the anode.
